# EUROPEAN PATENT SPECIFICATION

(11) **EP 4 343 825 B1**
(45) Date of publication and mention of the grant of the patent: **18.11.2026**
(21) Application number: 23161430.6
(22) Date of filing: 13.03.2023
(51) Int. Cl.: H10B 43/00, H10B 43/27, H10B 43/40, H10W 20/00, H10W 20/42

(54) **SEMICONDUCTOR STORAGE DEVICE AND METHOD OF MANUFACTURING SEMICONDUCTOR DEVICE**
HALBLEITERSPEICHERVORRICHTUNG UND VERFAHREN ZUR HERSTELLUNG EINER HALBLEITERVORRICHTUNG
DISPOSITIF DE STOCKAGE À SEMI-CONDUCTEUR ET PROCÉDÉ DE FABRICATION DE DISPOSITIF À SEMI-CONDUCTEUR

(30) Priority: 20.09.2022 JP 2022149422
(43) Date of publication of application: 27.03.2024
(73) Proprietor: Kioxia Corporation, Tokyo 108-0023 (JP)
(72) Inventor: Fujii, Kotaro, Tokyo, 108-0023 (JP)
(74) Representative: Hoffmann Eitle

(56) References cited:
- US-A1- 2015 200 201
- US-A1- 2018 151 490
- US-B1- 11 387 142

## Description

### CROSS-REFERENCE TO RELATED APPLICATION

### FIELD

Embodiments described herein relate generally to a semiconductor storage device and a method of manufacturing a semiconductor device.

### BACKGROUND ART

A semiconductor storage device including a multi-layered body, memory pillars, and bit lines is known. In the multi-layered body, a plurality of word lines and a plurality of insulating layers are alternately stacked one by one. Each memory pillar penetrates through the multi-layered body. The bit lines are connected to the memory pillars.

Specifically, US 2018/151490 A1 discloses a semiconductor device and method of fabricating the same, with, however, a different configuration regarding a first insulating layer, a conductor, a third portion as well as a first insulator in the sense and context of the present disclosure. Further, US 11,387, 142 B1 and US 2015/0200201 A1 have been found to be of relevance to the present invention.

### BRIEF DESCRIPTION OF THE DRAWINGS

FIG. 1 is a block diagram showing a part of a configuration of a semiconductor storage device according to an embodiment.
FIG. 2 is a view showing an equivalent circuit of a part of a memory cell array according to the embodiment.
FIG. 3 is a cross-sectional view showing a part of the semiconductor storage device according to the embodiment.
FIG. 4 is a cross-sectional view showing a region surrounded by a line F4 of the memory cell array shown in FIG. 3.
FIG. 5 is a cross-sectional view taken along line F5-F5 of the memory cell array shown in FIG. 4.
FIG. 6 is a cross-sectional view showing a region surrounded by a line F6 of the memory cell array shown in FIG. 3.
FIG. 7 is an enlarged cross-sectional view showing a cross-section taken along line F7-F7 of a part of the memory cell array shown in FIG. 6.
FIG. 8 is a cross-sectional view taken along line F8-F8 of the memory cell array shown in FIG. 6.
FIG. 9 is a cross-sectional explanatory view of a method of manufacturing the semiconductor storage device according to the embodiment.
FIG. 10 is a cross-sectional explanatory view of a method of manufacturing the semiconductor storage device according to the embodiment.
FIG. 11 is a cross-sectional explanatory view of a method of manufacturing the semiconductor storage device according to the embodiment.
FIG. 12 is a cross-sectional view showing a part of a memory cell array according to the invention.
FIG. 13 is a cross-sectional view showing a part of a memory cell array of a modified example according to the embodiment.

### DETAILED DESCRIPTION

The mentioned objects are achieved by the subject-matter of the independent claims. Further preferred embodiments of the present invention are defined in the dependent claims. A semiconductor storage device includes a first wiring, a second wiring, a first insulating layer, a first insulator, and a conductor. The first wiring extends in a first direction. The second wiring is apart from the first wiring in a second direction crossing the first direction. The second wiring extends in the first direction. The first insulating layer has a first portion, a second portion, and a third portion. The first portion is stacked on the first wiring in a third direction crossing the first direction and the second direction. The second portion is stacked on the second wiring the third direction. The third portion is on the opposite side of the first wiring and the second wiring with respect to the first portion and the second portion. The third portion extends in the second direction at least over the first portion and the second portion. The first insulator has a portion between the first portion and the second portion of the first insulating layer in the second direction. The conductor extends to the first insulating layer from the opposite side of the first wiring with respect to the first insulating layer. The conductor has a first conductive portion and a second conductive portion. The first conductive portion penetrates through the third portion and the first portion of the first insulating layer in the third direction. The first conductive portion is in contact with the first wiring. The second conductive portion penetrates through the third portion of the first insulating layer in the third direction. The second conductive portion is in contact with the first insulator. The second conductive portion has a level difference portion. The level difference portion is between the first conductive portion and the second conductive portion.

In the semiconductor storage device, the first insulator includes a first insulating material containing oxygen, and the first portion, the second portion, and the third portion of the first insulating layer include a second insulating material containing nitrogen.

In the semiconductor storage device, the first insulator includes a first insulating material containing oxygen, the first portion and the second portion of the first insulating layer include a second insulating material containing nitrogen, the third portion of the first insulating layer includes a third insulating material, the third insulating material contains nitrogen, and the third insulating material is different from the second insulating material.

The semiconductor storage device further includes: a third wiring on an opposite side of the first wiring with respect to the conductor, the third wiring being connected to the conductor, the third wiring extending in the first direction or the second direction, and a second insulator between the third wiring and the first insulating layer at a position out of the conductor, the second insulator including a fourth insulating material containing oxygen.

In the semiconductor storage device, the first wiring has a first end and a second end, the second end is on an opposite side of the first end in the third direction, the first end is closer to the first insulating layer than the second end, and a width of the second end in the second direction is larger than a width of the first end in the second direction.

In the semiconductor storage device, the first wiring is formed in a shape on one cross section parallel to the second direction and the third direction, and a width of the first wiring in the second direction gradually increases in a direction from the first end to the second end.

In the semiconductor storage device, the first wiring is formed in a trapezoid shape.

The semiconductor storage device further includes: a multi-layered body on an opposite side of the first insulating layer with respect to the first wiring and the second wiring, the multi-layered body including a plurality of gate electrode layers and a plurality of second insulating layers, the plurality of the gate electrode layers and the plurality of the second insulating layers being alternately stacked one by one in the third direction; and a columnar body extending in the third direction inside the multi-layered body, the columnar body including an insulating core, a channel layer, and a memory film, the channel layer being between the plurality of the gate electrode layers and the insulating core, the memory film being between the plurality of the gate electrode layers and the channel layer.

In the semiconductor storage device, the first wiring is a bit line electrically connected to the channel layer of the columnar body.

In the semiconductor storage device, the first wiring has a first side end and a second side end on one cross section parallel to the second direction and the third direction, the first side end being in contact with the first insulator, the second side end being on an opposite side of the first side end, and an inside of the first wiring is uniform over a region between the first side end and the second side end.

In the semiconductor storage device, in a case in which a line extending in the second direction along a boundary between the third portion of the first insulating layer and the first insulator on one cross section parallel to the second direction and the third direction is a first virtual line, an inside of the first insulating layer is uniform in a region between the first virtual line and the second wiring at least in the third direction.

In the semiconductor storage device, the third portion of the first insulating layer has a first surface and a second surface, the first surface being in contact with the first insulator in the third direction, the second surface being on an opposite side of the first surface, and the second surface does not have a recess having a depth greater than 10 nm in the third direction on a region overlapping the second wiring when viewed from the first direction on one cross section parallel to the second direction and the third direction.

A method of manufacturing a semiconductor device includes: forming a structure, the structure including a first wiring, a second wiring, a first insulating film, a second insulating film, and a first insulator, the first wiring extending in a first direction, the second wiring being apart from the first wiring in a second direction crossing the first direction, the second wiring extending in the first direction, the first insulating film being stacked on the first wiring in a third direction crossing the first direction and the second direction, the second insulating film being stacked on the second wiring in the third direction, the first insulator having a portion between the first insulating film and the second insulating film in the second direction; forming a first insulating layer having a first portion, a second portion, and a third portion by providing a third insulating film on the first insulating film, on the second insulating film, and on the first insulator, the third insulating film extending at least in the second direction, the first portion being formed by the first insulating film, the second portion being formed by the second insulating film, third portion being formed by the third insulating film; forming a second insulator on the first insulating layer; forming a hole penetrating through the second insulator and the first insulating layer in the third direction, the hole having a first portion and a second portion, the first portion penetrating through the third portion and the first portion of the first insulating layer in the third direction, the first portion reaching the first wiring, the second portion penetrating through the third portion of the first insulating layer in the third direction, the second portion reaching the first insulator, the second portion having a level difference portion, the level difference portion being between the first portion and the second portion; and forming a conductor inside the hole.

The method further includes: forming a metal layer parallel to the first direction and the second direction, the first wiring and the second wiring are formed by separating the metal layer by reactive ion etching such that the separated metal portions are in the second direction.

The method further includes: forming an insulating film parallel to the first direction and the second direction on the metal layer, the first insulating film and the second insulating film are formed by separating the metal layer and the insulating film by reactive ion etching such that the separated portions are in the second direction.

Hereinafter, a semiconductor storage device and a method of manufacturing a semiconductor device will be described with reference to the drawings. In the following description, configurations having the same or similar functions will be designated by the same reference signs. Duplicate descriptions of such configurations may be omitted. In the following description, each of components is represented by a reference sign to which a number or an alphabetical letter is appended at the end for distinction. In such components, the number or the alphabetical letter at the end may be omitted when they do not need to be distinguished from each other.

The term used in the present application are defined as follows.

The terms "parallel", "perpendicular", and "the same as" may also include "substantially parallel", "substantially perpendicular", and "substantially the same as", respectively. The term "connection" is not limited to "mechanical connection" but may also include "electrical connection". That is, "connection" is not limited to a case in which two members to be connected are directly connected to each other, but may also include a case in which two members to be connected are connected to each other with another member interposed therebetween. The term "adjacent to each other" is not limited to a case in which two members are in contact with each other, but may also include a case in which two members arranged separately from each other (for example, a case in which another member is interposed between two members). Although each of "layer" and "film" is a term for distinction of constituent elements, "layer" and "film" mean substantially the same constituent elements as each other. Accordingly, in the following description, "layer" and "film" may be replaced with each other.

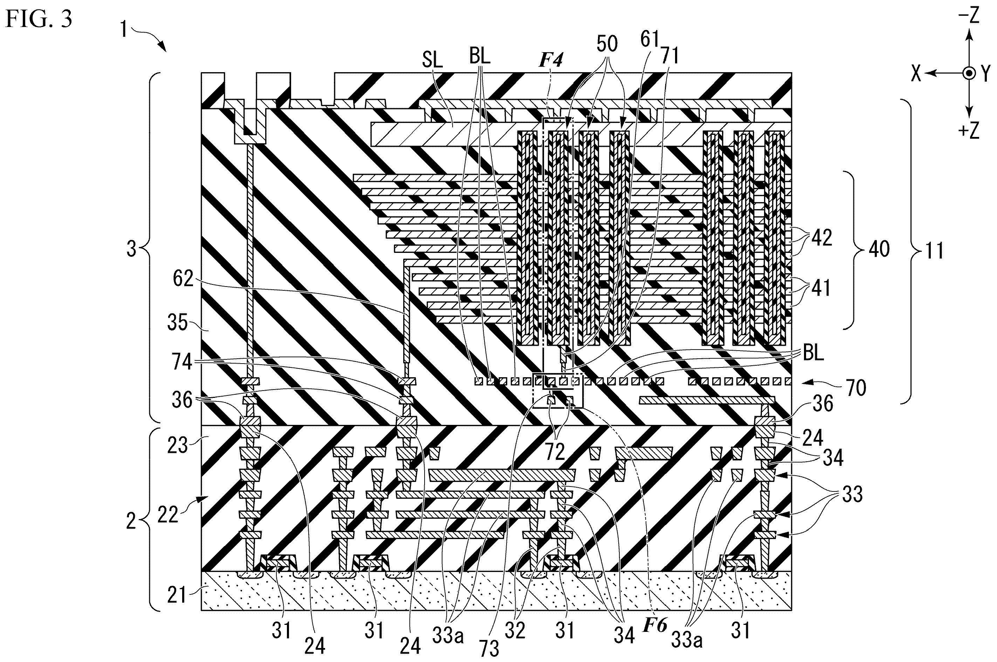

The X direction, the Y direction, the +Z direction, and the -Z direction are defined as follows. The X direction is a direction in which a word line WL described below (refer to FIG. 3) extends. The Y direction is a direction crossing (for example, is perpendicular to) the X direction. The Y direction is a direction in which a bit line BL described below (refer to FIG. 3) extends. Each of the +Z direction and the -Z direction is a direction crossing (for example, is perpendicular to) the X direction and the Y direction. The +Z direction is a direction from a multi-layered body 40 described below toward the bit line BL (refer to FIG. 3). The -Z direction is a direction opposite to the +Z direction. The +Z direction and the -Z direction will be simply referred to as a "Z direction" unless otherwise distinguished. In the following description, a position in the Z direction will be referred to as a height. However, this term is used for convenience of explanation but does not determine the direction of gravitational force. The Y direction is an example of a "first direction". The X direction is an example of a "second direction". The Z direction is an example of a "third direction".

### (Embodiment)

### <1. Configuration of Semiconductor Storage Device>

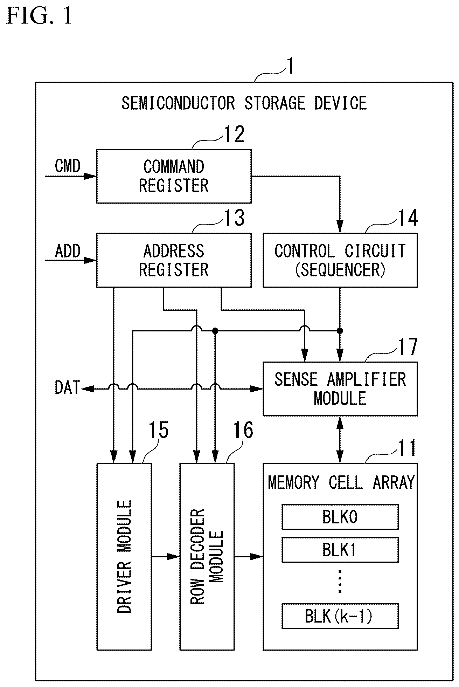

FIG. 1 is a block diagram showing a configuration of the semiconductor storage device 1. The semiconductor storage device 1 is, for example, a nonvolatile semiconductor storage device, such as a NAND type flash memory. The semiconductor storage device 1 can be connected to, for example, an external host device. The semiconductor storage device 1 is used as a storage space for the host device. The semiconductor storage device 1 includes, for example, a memory cell array 11, a command register 12, an address register 13, a control circuit (sequencer) 14, a driver module 15, a row decoder module 16, and a sense amplifier module 17.

The memory cell array 11 includes a plurality of blocks BLK, block BLK0 to BLK (k-1) (k is an integer greater than or equal to one). The block BLK is a collective body of a plurality of memory cell transistors. Each of the memory cell transistors is configured to store data non-volatilely. The block BLK is used as a data erase unit. A plurality of bit lines and a plurality of word lines are provided in the memory cell array 11. Each memory cell transistor is associated with one bit line and one word line.

The command register 12 stores a command CMD. The semiconductor storage device 1 receives the command CMD from the host device. The address register 13 stores address information ADD. The semiconductor storage device 1 receives the address information ADD from the host device. The control circuit 14 is a circuit configured to control various operations of the semiconductor storage device 1. For example, the control circuit 14 is configured to execute a write operation, a read operation, an erase operation, or the like of data on the basis of the command CMD stored in the command register 12.

The driver module 15 includes a voltage generation circuit. The driver module 15 is configured to generate voltages used in various operations of the semiconductor storage device 1. The row decoder module 16 transfers a voltage applied to a signal line corresponding to a selected word line to the selected word line. The sense amplifier module 17 applies a desired voltage to each bit line in the write operation. In the read operation, the sense amplifier module 17 determines a data value stored in each memory cell transistor on the basis of a voltage or a current of each bit line, and transfers the determination result as read data DAT to the host device.

### <2. Electrical Configuration of Memory Cell Array>

Next, an electrical configuration of the memory cell array 11 will be described.

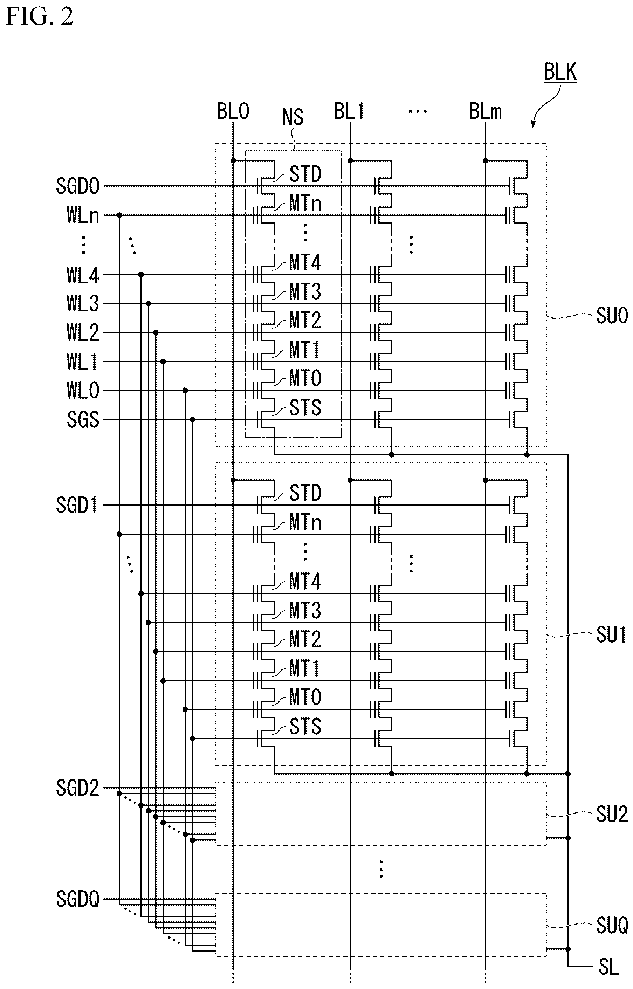

FIG. 2 is a view showing an equivalent circuit of a part of the memory cell array 11. FIG. 2 shows one block BLK included in the memory cell array 11. The block BLK includes a plurality of string units SU0 to SUQ (Q is an integer greater than or equal to one).

Each string unit SU includes a plurality of NAND strings NS. Each of the plurality of the NAND strings NS is associated with bit lines BL0 to BLm (m is an integer greater than or equal to one). Each NAND string NS includes, for example, a plurality of memory cell transistors MT0 to MTn (n is an integer greater than or equal to one), one or more drain-side select transistors STD, and one or more source-side select transistors STS.

In each NAND string NS, the memory cell transistors MT0 to MTn are electrically connected in series. Each of the memory cell transistors MT includes a control gate and a charge storage. The control gate of the memory cell transistor MT is electrically connected to any of word lines WL0 to WLn. In each memory cell transistor MT, electric charge is stored in the charge storage according to a voltage applied to the control gate via the word line WL, and thereby a data value is stored non-volatilely.

A drain of the drain-side select transistor STD is electrically connected to the bit line BL corresponding to the NAND string NS. A source of the drain-side select transistor STD is electrically connected to one end of the memory cell transistors MT0 to MTn electrically connected in series. A control gate of the drain-side select transistor STD is electrically connected to any one of drain-side select gate lines SGD0 to SGDQ. The drain-side select transistor STD is electrically connected to the row decoder module 16 via the drain-side select gate line SGD. The drain-side select transistor STD electrically connects the NAND string NS and the bit line BL when a predetermined voltage is applied to the corresponding drain-side select gate line SGD.

A drain of the source-side select transistor STS is electrically connected to the other end of the memory cell transistors MT0 to MTn that are electrically connected in series. A source of the source-side select transistor STS is electrically connected to the source line SL. A control gate of the source-side select transistor STS is electrically connected to the source-side select gate line SGS. The source-side select transistor STS electrically connects the NAND string NS and the source line SL when a predetermined voltage is applied to the source-side select gate line SGS.

In the same block BLK, the control gates of the memory cell transistors MT0 to MTn are mutually connected to the corresponding word lines WL0 to WLn, respectively. The control gates of the drain-side select transistors STD in the string units SU0 to SUQ are commonly connected to the corresponding select gate lines SGD0 to SGDQ, respectively. The control gate of the source-side select transistor STS is mutually connected to the select gate line SGS. In the memory cell array 11, the bit line BL is common to the NAND strings NS to which the same column address is assigned for each string unit SU.

### <3. Physical Configuration of Memory Cell Array>

Next, a physical configuration of the memory cell array 11 will be described.

FIG. 3 is a cross-sectional view showing a part of the semiconductor storage device 1. The semiconductor storage device 1 includes, for example, a first chip 2 and a second chip 3.

### <3.1 First Chip>

First of all, the first chip 2 will be described. The first chip 2 is a circuit chip including a peripheral circuit 22. The first chip 2 includes, for example, a semiconductor substrate 21, the peripheral circuit 22, an insulator 23, and a plurality of pads 24.

The semiconductor substrate 21 is, for example, a substrate serving as a base of the first chip 2. At least part of the semiconductor substrate 21 is formed in a plate shape extending in the X direction and the Y direction. The semiconductor substrate 21 is formed of, for example, a semiconductor material such as silicon.

The peripheral circuit 22 is a circuit configured to operate the memory cell array 11 mentioned above. The peripheral circuit 22 includes one or more of the command register 12, the address register 13, the control circuit 14, the driver module 15, the row decoder module 16, and the sense amplifier module 17 mentioned above. The peripheral circuit 22 includes, for example, a plurality of transistors 31, a plurality of contacts 32, a plurality of wiring layers 33, and a plurality of vias 34.

The plurality of the transistors 31 are provided on the semiconductor substrate 21. Each of the transistors 31 includes, for example, a source region and a drain region which are formed on an upper surface portion of the semiconductor substrate 21. Each of the plurality of the contacts 32 has electroconductivity. Each of the plurality of the contacts 32 extends in the Z direction. Each of the plurality of the contacts 32 is in contact with the source region, the drain region, or a gate electrode of the transistor 31.

The height positions of the plurality of the wiring layers 33 in the Z direction are different from each other. Each of the plurality of the wiring layers 33 has a plurality of wirings 33a extending in the X direction or the Y direction. Each of the plurality of the vias 34 extends in the Z direction. For example, the plurality of the vias 34 include: a via 34 (first via) that connects two wirings 33a; and a via 34 (second via) that connects the wiring 33a and the pad 24. The height positions of the two wirings 33a in the Z direction are different from each other.

The insulator 23 covers the plurality of the transistors 31, the plurality of the contacts 32, the plurality of the wiring layers 33, and the plurality of the vias 34. The plurality of the pads 24 are provided on a surface of the insulator 23. Each of the plurality of the pads 24 is electrically connected to the wiring 33a via the via 34.

### <3.2 Second Chip>

Next, the second chip 3 will be described. The second chip 3 is an array chip including the memory cell array 11. The second chip 3 includes, for example, the memory cell array 11, an insulator 35, and a plurality of pads 36. The insulator 35 and the plurality of the pads 36 will be described here. The memory cell array 11 will be described later.

The insulator 35 covers the memory cell array 11. The plurality of the pads 36 are provided on a surface of the insulator 35. Each of the plurality of the pads 36 is electrically connected to a wiring (for example, a wiring 72 or a wiring 74) included in a wiring part 70 of the memory cell array 11 described below. In the embodiment, the plurality of the pads 24 of the first chip 2 are attached to the plurality of the pads 36 of the second chip 3 in a state in which the plurality of the pads 24 face the plurality of the pads 36 such that the plurality of the pads 24 correspond one-to-one to the plurality of the pads 36. Accordingly, the first chip 2 and the second chip 3 are combined together.

### <4. Physical Configuration of Memory Cell Array>

Next, a physical configuration of the memory cell array 11 will be described.

As shown in FIG. 3, the memory cell array 11 includes a multi-layered body 40, the source line SL, a plurality of memory pillars 50, a plurality of contacts 61 for the memory pillars, a plurality of contacts 62 for the conductive layers, and the wiring part 70. In FIG. 3, one contact 61 is shown, and one contact 62 is shown.

### <4.1 Multi-Layered Body>

Next, the multi-layered body 40 will be described.

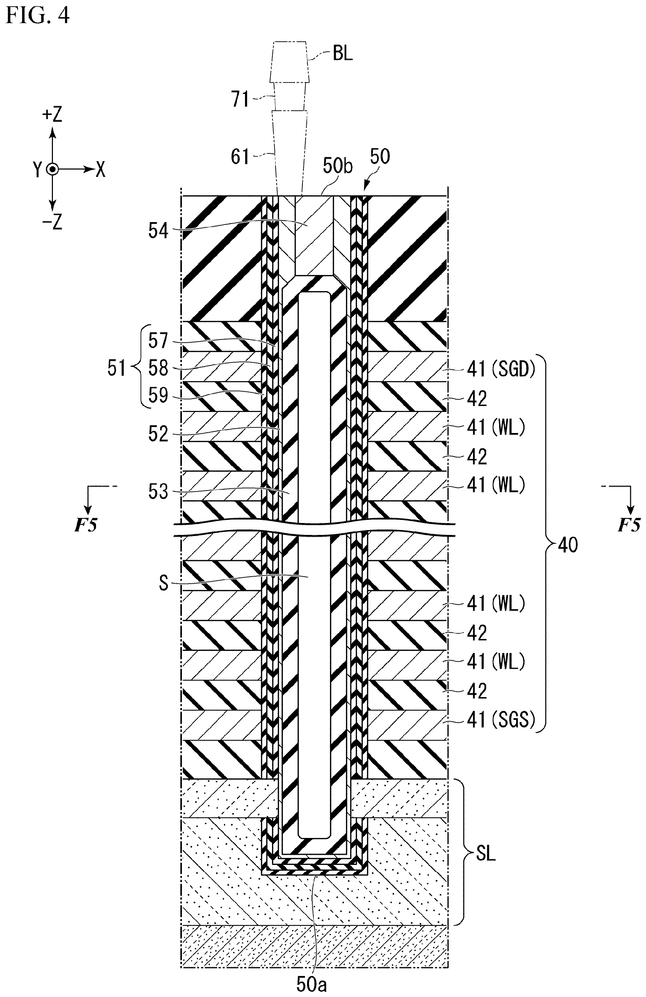

FIG. 4 is a cross-sectional view showing a region surrounded by a line F4 of the memory cell array 11 shown in FIG. 3. Note that, FIG. 4 is vertically inverted with respect to FIG. 3. In the following explanation, for convenience, a side (that is, a side in the +Z direction) at which the bit line BL is located when viewed from the multi-layered body 40 may be referred to as "upper". A side (that is, a side in the -Z direction) opposite thereof may be referred to as "lower". However, the terms are used for convenience of explanation but do not determine the direction of gravitational force of the semiconductor storage device 1.

The multi-layered body 40 includes a plurality of conductive layers 41 and a plurality of insulating layers 42. The plurality of the conductive layers 41 and the plurality of the insulating layers 42 are alternately stacked one by one in the Z direction.

Each of the conductive layers 41 is parallel to the X direction and the Y direction. Each of the plurality of the conductive layers 41 is formed of an electroconductive material such as, for example, tungsten. The conductive layer 41 is an example of a "gate electrode layer".

Of the plurality of the conductive layers 41, one or more conductive layers 41 (for example, a plurality of conductive layers) located at an upper position function as the drain-side select gate line SGD. The drain-side select gate line SGD is commonly provided for each of the plurality of the memory pillars 50 aligned in the X direction or the Y direction. The drain-side select gate line SGD crosses a channel layer 52 (to be described later) of each of the memory pillars 50. The crossing portion of the drain-side select gate line SGD and the channel layer 52 functions as the drain-side select transistor STD described above.

Of the plurality of the conductive layers 41, one or more conductive layers 41 (for example, a plurality of conductive layers) located at a lower position function as the source-side select gate line SGS. The source-side select gate line SGS is commonly provided for each of the plurality of the memory pillars 50 aligned in the X direction or the Y direction. The source-side select gate line SGS crosses the channel layer 52 of each of the memory pillars 50. The crossing portion of the source-side select gate line SGS and the channel layer 52 functions as the source-side select transistor STS described above.

Of the plurality of the conductive layers 41, at least one of the remaining conductive layers 41 provided between the conductive layers 41 functions as the drain-side select gate line SGD and the source-side select gate line SGS. The remaining conductive layers 41 function as the word line WL. The word line WL is commonly provided for each of the plurality of the memory pillars 50 aligned in the X direction and the Y direction. The word line WL crosses the channel layer 52 of each of the memory pillars 50. In the embodiment, the crossing portion of the word line WL and the channel layer 52 functions as the memory cell transistor MT. The memory cell transistor MT will be particularly described below.

The insulating layer 42 is an interlayer insulating film provided between two conductive layers 41 adjacent to each other in the Z direction and insulating the two conductive layers 41. The insulating layer 42 is parallel to the X direction and the Y direction. The insulating layer 42 is formed of an insulating material such as a film containing silicon and oxygen (for example, SiO₂ film). The insulating layer 42 is an example of a "second insulating layer".

### <4.2 Source Line>

The source line SL is disposed on the side in the -Z direction with respect to the multi-layered body 40. The source line SL is a plate-shaped conductive layer spreading in the X direction and the Y direction. The source line SL is formed of an electroconductive material such as a conductive layer containing polysilicon or tungsten.

### <4.3 Memory Pillar>

The plurality of the memory pillars 50 extend in the Z direction. The plurality of the memory pillars 50 penetrate through the multi-layered body 40. Each memory pillar 50 has a lower end 50a and an upper end 50b. The lower end 50a of each memory pillar 50 is in contact with the source line SL. On the other hand, the upper end 50b of each memory pillar 50 is in contact with the contact 61 described below. The memory pillar 50 is an example of a "columnar body".

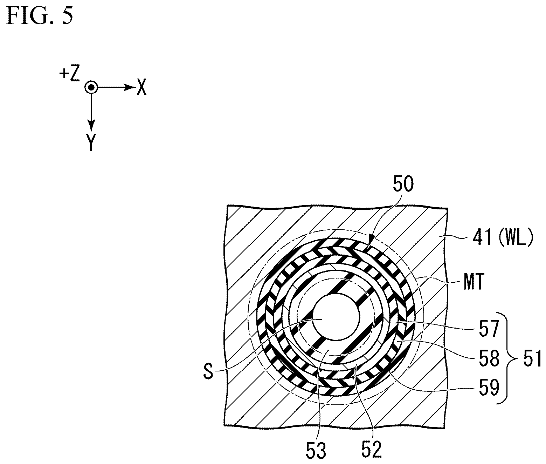

FIG. 5 is a cross-sectional view taken along line F5-F5 of the memory cell array 11 shown in FIG. 4. The memory pillar 50 includes, for example, a memory film 51 (multi-layered film), the channel layer 52, an insulating core 53, and a cap part 54 (refer to FIG. 4).

The memory film 51 is provided on an outer circumferential side of the channel layer 52. The memory film 51 is located between the plurality of the conductive layers 41 and the channel layer 52. The memory film 51 includes, for example, a tunnel insulating film 57, a charge trap film 58, and a block insulating film 59.

The tunnel insulating film 57 is provided between the channel layer 52 and the charge trap film 58. The tunnel insulating film 57 is formed in, for example, an annular shape along an outer circumferential surface of the channel layer 52. The tunnel insulating film 57 extends in the Z direction parallel to the channel layer 52. The tunnel insulating film 57 extends, for example, through the entire length of the memory pillar 50 in the Z direction. The tunnel insulating film 57 is a potential barrier between the channel layer 52 and the charge trap film 58. The tunnel insulating film 57 is formed of a film containing silicon and oxygen or a film containing silicon, oxygen, and nitrogen.

The charge trap film 58 is provided on an outer circumferential side of the tunnel insulating film 57. The charge trap film 58 is located between the tunnel insulating film 57 and the block insulating film 59. The charge trap film 58 extends in the Z direction. The charge trap film 58 extends, for example, through the entire length of the memory pillar 50 in the Z direction. The charge trap film 58 has a large number of crystal defects (trapping levels). The charge trap film 58 is a functional film capable of trapping electric charge in those crystal defects. The charge trap film 58 is formed of, for example, a film containing silicon and nitrogen. A portion of the charge trap film 58 adjacent to each word line WL is an example of a "charge storage" that can store information by accumulating electric charge.

The block insulating film 59 is provided on an outer circumferential side of the charge trap film 58. The block insulating film 59 is located between the plurality of the conductive layers 41 and the charge trap film 58. The block insulating film 59 is an insulating film that suppresses back tunneling. Back tunneling is a phenomenon in which electric charge returns from the word line WL to the charge trap film 58. The block insulating film 59 extends in the Z direction. The block insulating film 59 extends, for example, through the entire length of the memory pillar 50 in the Z direction. The block insulating film 59 is a multi-layered structure film. In the multi-layered structure film, a plurality of insulating films such as, for example, a film containing silicon and oxygen or a film containing a metal and oxygen are stacked. An example of the film containing a metal and oxygen is aluminum oxide. The block insulating film 59 may contain a high dielectric constant material (High-k material) such as silicon nitride or hafnium oxide.

The channel layer 52 is provided on an inner side of the memory film 51. The channel layer 52 is formed in an annular shape. The channel layer 52 extends in the Z direction. The channel layer 52 extends, for example, through the entire length of the memory pillar 50 in the Z direction. The channel layer 52 is formed of a semiconductor material such as polysilicon. The channel layer 52 may be doped with impurities. When a voltage is applied to the word line WL, a channel to electrically connect the bit line BL and the source line SL is formed in the channel layer 52.

Therefore, at the same height as each word line WL, a metal-Al-nitride-oxide-silicon (MANOS) type memory cell transistor MT is formed by an end portion of the word line WL adjacent to the memory pillar 50, the block insulating film 59, the charge trap film 58, the tunnel insulating film 57, and the channel layer 52. Furthermore, the memory film 51 may include a floating gate type charge storage (floating gate electrode) as the charge storage instead of the charge trap film 58. The floating gate electrode is formed of, for example, polysilicon containing impurities.

The insulating core 53 is provided on an inner side of the channel layer 52. The insulating core 53 fills a part of the inside of the channel layer 52. The insulating core 53 is formed of an insulating material such as a film containing silicon and oxygen. A part of the insulating core 53 may be formed in an annular shape along an inner circumferential surface of the channel layer 52, and may have a space (air gap) S therein. The insulating core 53 extends in the Z direction. The insulating core 53 extends over, for example, most of the memory pillar 50 in the Z direction except for an upper end portion of the memory pillar 50 (refer to FIG. 4).

Next, returning to FIG. 4, the cap part 54 will be described. The cap part 54 is provided above the insulating core 53. The cap part 54 is a semiconductor part formed of a semiconductor material such as amorphous silicon or polysilicon. The cap part 54 may be doped with impurities. The cap part 54 is disposed at an inner-peripheral side of the upper end portion of the memory film 51. The cap part 54 is formed integrally with the channel layer 52. The cap part 54 forms an upper end portion of the memory pillar 50 together with the upper end portion of the channel layer 52. The contact 61 for the memory pillar is in contact with the cap part 54 in the Z direction.

### <4.4 Contact for Memory Pillar>

Next, the contact 61 for the memory pillar will be described. The contact 61 is an electrical connection portion that electrically connects the memory pillar 50 and the bit line BL included in the wiring part 70. The plurality of the contacts 61 are disposed at positions corresponding one-to-one to the plurality of the memory pillars 50 when viewed from above. Each contact 61 extends in the Z direction. A lower end of each contact 61 is in contact with the upper end 50b of the memory pillar 50. On the other hand, an upper end of each contact 61 is connected to the bit line BL via a via 71 provided above the contact 61 described below.

### <4.5 Contact for Conductive Layer>

Next, returning to FIG. 3, the contact 62 for the conductive layer will be described. The contact 62 is an electrical connection portion that electrically connects the conductive layer 41 and the wiring 74 included in the wiring part 70. The plurality of the contacts 62 are disposed so as to correspond to a staircase region. **In** the staircase region, for example, the end portions of the plurality of the conductive layers 41 are disposed in the multi-layered body 40 in a staircase pattern. The plurality of the contacts 62 are disposed at positions corresponding one-to-one to the plurality of the conductive layers 41 when viewed from above. Each of the plurality of the contacts 62 extends in the Z direction. The lengths of the plurality of the contacts 62 in the Z direction are different from each other.

### <4.6 Wiring Part>

Next, the wiring part 70 will be described. The wiring part 70 is disposed between, for example, the multi-layered body 40 and the semiconductor substrate 21 (refer to FIG. 3). The wiring part 70 includes, for example, the plurality of the bit lines BL, the plurality of the vias 71, a plurality of wirings 72, a plurality of vias 73, and a plurality of wirings 74.

Each of the plurality of the bit lines BL is a wiring that controls a state of applying a voltage for selecting the memory pillar 50. The plurality of the bit lines BL are arranged next to each other at a distance in the X direction. The plurality of the bit lines BL extend in the Y direction. The plurality of the bit lines BL are parallel to each other. Each bit line BL is disposed at the position where at least part of each bit line BL overlaps the corresponding to contact 61 for the memory pillar in the Z direction. The via 71 is provided between the bit line BL and the contact 61. The via 71 connects the bit line BL and the contact 61. The bit line BL is electrically connected to the channel layer 52 of the memory pillar 50 via the via 71 and the contact 61. Consequently, by combination of the word line WL and the bit line BL, the memory cell transistor MT can be optionally selected from the plurality of three-dimensionally arranged memory cell transistors MT. The bit line BL will be particularly described below.

Each wiring 72 is an electrical connection portion that electrically connects the bit line BL and the pad 36. The plurality of the wirings 72 are disposed on the side in the +Z direction with respect to, for example, the plurality of the bit lines BL. Each wiring 72 extends in, for example, the X direction or the Y direction. The via 73 is provided between the wiring 72 and the bit line BL. The via 73 connects the wiring 72 and the bit line BL. The wiring 72 and the via 73 will be particularly described below.

Each wiring 74 is a wiring that controls a state of applying a voltage for selecting the conductive layer 41 (the word line WL, the drain-side select gate line SGD, or the source-side select gate line SGS). Each wiring 74 is an electrical connection portion that electrically connects the contact 62 and the pad 36.

### <5. Connection Structure between Bit Line and Wiring>

Next, a connection structure of the bit line BL and the wiring 72 will be described.

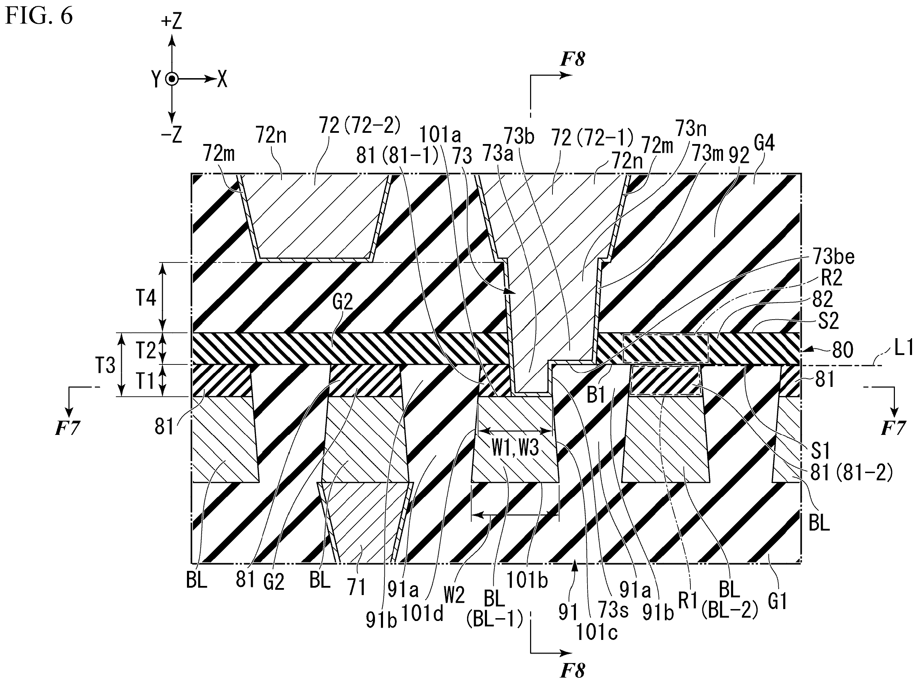

FIG. 6 is a cross-sectional view showing a region surrounded by a line F6 of the memory cell array 11 shown in FIG. 3. Note that, FIG. 6 is vertically inverted with respect to FIG. 3. As shown in FIG. 6, the memory cell array 11 includes the plurality of the bit lines BL mentioned above, an insulating layer 80, a first insulator 91, the plurality of the wirings 72 mentioned above, the plurality of the vias 73, and a second insulator 92. In FIG. 6, one via 73 is shown. Hereinbelow, the memory cell array 11 will be particularly described.

### <5.1 Bit Line>

The plurality of the bit lines BL are next to each other at a distance in the X direction. In the following explanation, for convenience, one bit line BL-1 included in the plurality of the bit lines BL is referred to as a "first bit line BL-1", and one bit line BL adjacent to the first bit line BL-1 is referred to as a "second bit line BL-2". The first bit line BL-1 is an example of the "first wiring". The second bit line BL-2 is an example of the "second wiring".

The bit line BL is formed by a wiring material that can be processed by, for example, reactive ion etching (RIE: Reactive Ion Etching). The bit line BL is formed by, for example, tungsten, molybdenum, chromium, or ruthenium.

As shown in FIG. 6, each bit line BL has a first end 101a and a second end 101b on a cross section parallel to the X direction and the Z direction. The first end 101a is an end at the side where the insulating layer 80 is located in the Z direction. The first end 101a is in contact with a first layer part 81 of the insulating layer 80 in the Z direction described below. The second end 101b is an end on the opposite side of the first end 101a in the Z direction. That is, the second end 101b is an end at the side where the multi-layered body 40 is located. The second end 101b is in touch with the via 71 in the Z direction. The first end 101a is closer to the insulating layer 80 than the second end 101b.

In the embodiment, the plurality of the bit lines BL are patterned by reactive ion etching. Consequently, regarding each bit line BL, the width W2 of the second end 101b of the bit line BL in the X direction is larger than the width W1 of the first end 101a of the bit line BL in the X direction. Each bit line BL is formed in a trapezoid shape on one cross section parallel to the X direction and the Z direction. The bit line BL forming the trapezoid shape has a long side and a short side parallel to each other. The first end 101a corresponds to the short side of the trapezoid shape. The second end 101b corresponds to the long side of the trapezoid shape. In other words, the width in the X direction of the bit line BL gradually increases in the direction from the first end 101a to the second end 101b. That is, the width in the X direction of the bit line BL gradually increases in the direction approaching the multi-layered body 40 in the -Z direction.

In the embodiment, each bit line BL does not necessarily have a barrier metal layer. In other words, each bit line BL formed in the trapezoid shape has a first side end 101c and a second side end 101d on one cross section parallel to the X direction and the Z direction. The second side end 101d is on the opposite side of the first side end 101c. The first side end 101c corresponds to a first lateral side of the trapezoid shape. The second side end 101d corresponds to a second lateral side of the trapezoid shape. The first side end 101c is in contact with the first insulator 91. The second side end 101d is in contact with the first insulator 91 at a different position from that of the first side end 101c. Particularly, the inside of the bit line BL is uniform between the first side end 101c and the second side end 101d. For example, a profile of the material forming the bit line BL is uniform over a region between the first side end 101c and the second side end 101d. That is, the same material (for example, tungsten or molybdenum) is continuous between the first side end 101c and the second side end 101d inside the bit line BL.

### <5.2 Insulating Layer>

For example, the displacement in position of the via 73 from the bit line BL may occur. The insulating layer 80 is an insulating layer for reducing an effect due to such displacement of the via 73. The insulating layer 80 is disposed on the opposite side of the multi-layered body 40 with respect to the plurality of the bit lines BL (that is, on the side in the +Z direction). The insulating layer 80 includes, the plurality of the first layer parts 81 and a second layer part 82. Note that, for convenience of explanation with reference to FIG. 6, the first layer part 81 and the second layer part 82 are represented by different hatchings from each other. However, the first layer part 81 and the second layer part 82 include, in an example not encompassed by the wording of the claims, the same material and are present in one body. Consequently, a boundary between the first layer part 81 and the second layer part 82 disappears, and the first layer part 81 and the second layer part 82 is present as one insulating layer 80. The insulating layer 80 is an example of a "first insulating layer".

### <5.2.1 First Layer Part>

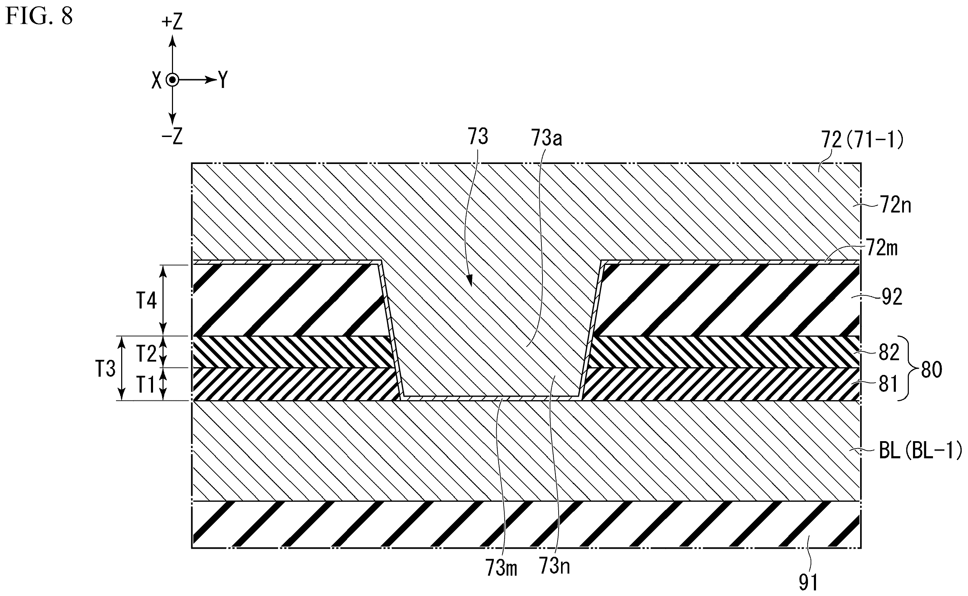

The plurality of the first layer parts 81 are provided so as to correspond one-to-one to the plurality of the bit lines BL. The first layer part 81 is a part, for example, having electrical insulation in the insulating layer 80. The first layer part 81 is located on the side in the +Z direction with respect to the corresponding bit line BL. The first layer part 81 is stacked on the bit line BL. The first layer part 81 extends in the Y direction along a surface of the bit line BL (refer to FIG. 8). The plurality of the first layer parts 81 are arranged next to each other at a distance in the X direction. The first layer part 81 (the first layer part 81-1) stacked on the first bit line BL-1 is an example of "a first portion of a first insulating layer". The first layer part 81 (the first layer part 81-2) stacked on the second bit line BL-2 is an example of "a second portion of a first insulating layer".

The first layer part 81 includes, for example, an insulating material G2 containing nitrogen. The insulating material G2 is any one of, for example, a film containing silicon and nitrogen (for example, SiN), a film containing silicon, carbon, nitrogen (for example, SiCN), and a film containing silicon, oxygen, and nitrogen (for example, SiON). In consideration of an etching selection ratio of the first layer part 81 to the first insulator 91 described below, it is preferable to use silicon nitride (SiN) or silicon carbonitride (SiCN) as the insulating material G2.

In consideration of an interlayer capacitance between the wiring 72 and the bit line BL described below, that is, for reducing the interlayer capacitance, it is preferable to use silicon carbonitride (SiCN) as the insulating material G2 in comparison with silicon nitride (SiN). On the other hand, in further consideration of the etching selection ratio of the first layer part 81 to the first insulator 91 described below, that is, for increasing, the etching selection ratio, it is preferable to use silicon nitride (SiN) as the insulating material G2 in comparison with silicon carbonitride (SiCN). The insulating material G2 is an example of a "second insulating material".

In the embodiment, the maximum width W3 of the first layer part 81 in the X direction is larger than the thickness T1 of the first layer part 81 in the Z direction. The maximum width W3 is, for example, the same as the width W1 of the first end 101a of the bit line BL in the X direction. The plurality of the first layer parts 81 and the bit line BL are patterned by, for example, reactive ion etching. Consequently, the width W3 of the first layer part 81 in the X direction on the first end 101a is larger than the width in the X direction on the second layer part 82. The first layer part 81 is formed in a trapezoid shape on one cross section parallel to the X direction and the Z direction. The first layer part 81 forming the trapezoid shape has a long side and a short side parallel to each other.

In other words, the width in the X direction of the first layer part 81 gradually increases in the direction from the short side to the long side, that is, in the direction approaching the multi-layered body 40 in the -Z direction.

In the embodiment, a void or a seam of films is not present inside the first layer part 81 with the exception of the unintentional occurrence of a void or a seam of films due to variations in manufacturing process or the like. In other words, for example, a line extending in the X direction along a boundary B1 between the second layer part 82 and the first insulator 91 described below on one cross section parallel to the X direction and the Z direction is a first virtual line L1. In this case, the inside of the insulating layer 80 is uniform in a region between the first virtual line L1 and the second bit line BL-2 (a region R1 represented by a dashed-dotted line in FIG. 6) at least in the Z direction. That is, a void or a seam of films is not present on the region R1 with the exception of the unintentional occurrence of a void or a seam of films due to variations in manufacturing process or the like.

### <5.2.2 Second Layer Part>

The second layer part 82 is a portion functioning as, for example, a stopper layer with respect to formation of a hole when forming the hole for the via 73. The second layer part 82 is located on the side in the +Z direction with respect to the plurality of the first layer parts 81. That is, the second layer part 82 is located on the opposite side of the plurality of the bit lines BL with respect to the plurality of the first layer parts 81. The second layer part 82 extends at least in the X direction over the plurality of the first layer parts 81. In the embodiment, the second layer part 82 expands in the X direction and the Y direction. The thickness T2 of the second layer part 82 in the Z direction is, for example, the same as the thickness T1 of the first layer part 81 in the Z direction. In other words, the maximum width W3 of the first layer part 81 in the X direction is larger than the thickness T2 of the second layer part 82 in the Z direction. The second layer part 82 is an example of "a third portion of a first insulating layer".

The second layer part 82 includes the insulating material G2 that is, in an example not encompassed by the wording of the claims, the same as the first layer part 81. That is, the second layer part 82 includes, for example, a film containing silicon and nitrogen (for example, SiN), a film containing silicon, carbon, nitrogen (for example, SiCN), or a film containing silicon, oxygen, and nitrogen (for example, SiON). In the example not encompassed by the wording of the claims, the first layer part 81 and the second layer part 82 are formed using the same material.

In the embodiment, the second layer part 82 has a first surface S1 and a second surface S2. The first surface S1 is in contact with the first insulator 91 in the Z direction. The second surface S2 is located on the opposite side of the first surface S1. The second surface S2 is a flat surface parallel to the X direction and the Y direction. In other words, the second surface S2 does not have a recess having a depth greater than 10 nm in the Z direction in a region overlapping the first wiring when viewed at least from the Z direction on one cross section parallel to the X direction and the Z direction. Here, the region is a region R2 is represented by a dashed-dotted line in FIG. 6.

### <5.3 First Insulator>

The first insulator 91 is disposed on the side in the -Z direction with respect to the insulating layer 80. The first insulator 91 has a portion 91a and a portion 91b. The portion 91a is located between the plurality of the bit lines BL in the X direction. The portion 91b is located between the plurality of the first layer parts 81 of the insulating layer 80 in the X direction. The portion 91b of the first insulator 91 is in contact with the first surface S1 of the second layer part 82 of the insulating layer 80 in the Z direction. The first insulator 91 includes, for example, an insulating material G1 containing oxygen. The insulating material G1 is, for example, a film containing silicon and oxygen (for example, SiO₂). The insulating material G1 is an example of a "first insulating material".

### <5.4 Wiring>

The plurality of the wirings 72 are disposed on the side in the +Z direction with respect to the insulating layer 80. As shown in FIG. 6, for example, the wiring 72 extends in the Y direction. Instead of this, the wiring 72 may extend in the X direction.

Of the plurality of the wirings 72, the wiring 72-1 connected to the first bit line BL-1 is an example of a "third wiring". The wiring 72-1 is located on the opposite side of the first bit line BL-1 with respect to the via 73. The wiring 72-1 is connected to the via 73. The wiring 72-1 is electrically connected to the first bit line BL-1 via the via 73. In the present application, the term "connected to a via (conductor)" is not limited to a case in which the via (conductor) and the wiring are independently formed and connected to each other, but may also include a case in which the via (conductor) and the wiring are integrally formed as one body and thereby connected to each other.

Of the plurality of the wirings 72, the wiring 72-2 not connected to the first bit line BL-1 is an example of a "fourth wiring". The wiring 72-2 is disposed adjacent to, for example, the wiring 72-1 in the X direction.

In the embodiment, the wiring 72 includes a surface layer 72m and a main part 72n. The main part 72n is provided inside the surface layer 72m. The surface layer 72m is, for example, a barrier metal layer. The surface layer 72m is formed of, for example, an electroconductive material containing titanium. The main part 72n is formed of, for example, an electroconductive material such as a metal material. The main part 72n is formed of, for example, tungsten, molybdenum, copper, or the like.

### <5.5 Via>

The via 73 is an electrical connection portion that electrically connects the wiring 72 and the bit line BL (for example, the wiring 72-1 and the first bit line BL-1). The via 73 is disposed between the wiring 72 and the bit line BL in the Z direction. The via 73 extends in the Z direction. The via 73 extends toward the insulating layer 80 from the opposite side of the first bit line BL-1 with respect to the insulating layer 80. The via 73 is an example of a "conductor". The via 73 has, for example, a first conductive portion 73a and a second conductive portion 73b.

The first conductive portion 73a is a portion of the via 73 which overlaps the bit line BL when viewed from the Z direction. The first conductive portion 73a penetrates through the second layer part 82 and the first layer part 81 of the insulating layer 80 in the Z direction. The first conductive portion 73a is in contact with the bit line BL. The first conductive portion 73a is electrically connected to the wiring 72 and the bit line BL.

The second conductive portion 73b is a portion of the via 73 which is disposed at a position out of the bit line BL when viewed from the Z direction. The second conductive portion 73b is adjacent to the first conductive portion 73a in the X direction. The second conductive portion 73b penetrates through the second layer part 82 of the insulating layer 80 in the Z direction. The second conductive portion 73b is in contact with the first insulator 91. An end 73be of the second conductive portion 73b on the side in the -Z direction is located at, for example, the boundary B1 between the second layer part 82 of the insulating layer 80 and the first insulator 91. A level difference portion 73s in the Z direction is formed between the first conductive portion 73a and the second conductive portion 73b. The second conductive portion 73b is not connected to the second bit line BL-2. In other words, the second bit line BL-2 is a non-connection object with respect to the second conductive portion 73b. The second conductive portion 73b is away from the second bit line BL-2 by an amount of a distance at least larger than the thickness T1 of the first layer part 81 of the insulating layer 80 in the Z direction.

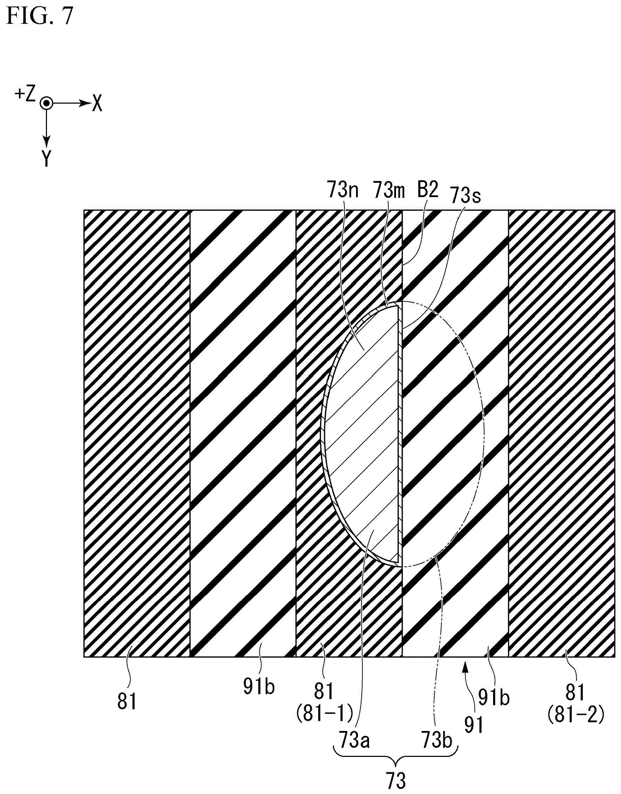

FIG. 7 is an enlarged cross-sectional view showing a cross-section taken along line F7-F7 of a part of the memory cell array **11** shown in FIG. 6. In the embodiment, the via 73 is formed in an ellipse shape on a cross section parallel to the X direction and the Y direction. The minor axis of the ellipse shape is parallel to the X direction. The major axis of the ellipse shape is parallel to the Y direction. The level difference portion 73s provided between the first conductive portion 73a and the second conductive portion 73b extends in the Y direction along the boundary B2 between the first layer part 81 and the first insulator 91.

Returning to FIG. 6, explanation is continued. In the embodiment, the via 73 includes a surface layer 73m and a main part 73n. The main part 73n is provided inside the surface layer 73m. The surface layer 73m is, for example, a barrier metal layer. The surface layer 73m is formed of, for example, an electroconductive material containing titanium. The main part 73n is formed of, for example, an electroconductive material such as a metal material. The main part 73n is formed of, for example, tungsten, molybdenum, copper, or the like.

### <5.6 Second Insulator>

The second insulator 92 is disposed on the side in the +Z direction with respect to the insulating layer 80. The second insulator 92 expands in the X direction and the Y direction along the second surface S2 of the second layer part 82 of the insulating layer 80. The second insulator 92 includes, for example, an insulating material G4 containing oxygen. The insulating material G4 is, for example, a film containing silicon and oxygen (for example, SiO₂). The insulating material G4 may be the same as or different from the insulating material G1. The insulating material G4 is an example of a "fourth insulating material".

FIG. 8 is a cross-sectional view taken along line F8-F8 of a part of the memory cell array 11 shown in FIG. 6. At a position out of the via 73, a part of the second insulator 92 is disposed between the wiring 72 (for example, the wiring 72-1) and the second layer part 82 of the insulating layer 80. In the embodiment, the thickness T4 in the Z direction of the second insulator 92 between the wiring 72 (for example, the wiring 72-1) and the second layer part 82 of the insulating layer 80 is larger than the thickness T3 in the Z direction of the insulating layer 80. The thickness T3 in the Z direction of the insulating layer 80 is a total of, for example, the thickness T1 in the Z direction of the first layer part 81 and the thickness T2 in the Z direction of the second layer part 82.

As shown in FIG. 6, another part of the second insulator 92 is disposed between the wiring 72 (for example, the wiring 72-2) and the second layer part 82 of the insulating layer 80. The thickness T4 in the Z direction of the second insulator 92 between the wiring 72 (for example, the wiring 72-2) and the second layer part 82 of the insulating layer 80 is larger than the thickness T3 in the Z direction of the insulating layer 80.

### <6. Manufacturing Method>

Next, a method of manufacturing the semiconductor storage device 1 will be described.

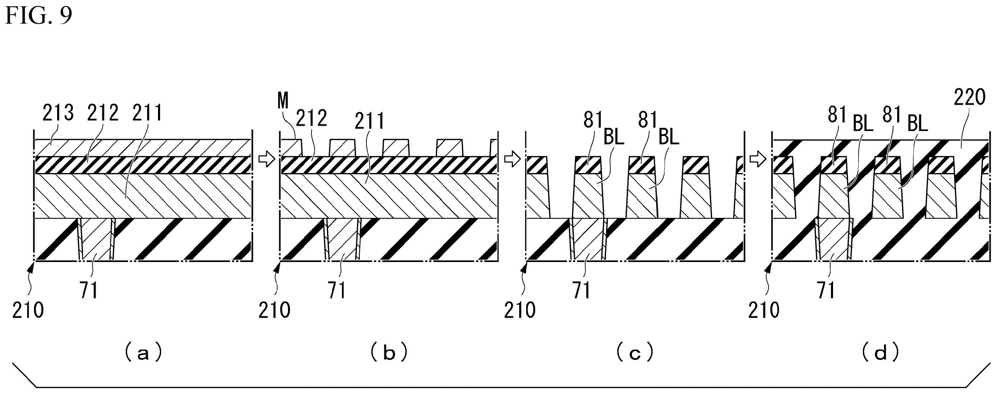

FIGS. 9 to 11 are cross-sectional explanatory views showing a method of manufacturing the semiconductor storage device 1. Note that, the multi-layered body 40, the memory pillar 50, the contact 61, and the via 71, or the like of the semiconductor storage device 1 can be manufactured by a known method. Hereinbelow, a method of forming the bit line BL, the insulating layer 80, the wiring 72, and the via 73 will be described.

First of all, as shown in part (a) of FIG. 9, a structure 210 including the multi-layered body 40, the memory pillar 50, the contact 61, and the via 71 is formed. Next, a metal layer 211 is formed on the structure 210 by chemical vapor deposition (CVD: Chemical Vapor Deposition). The metal layer 211 is formed in a plate shape extending in the X direction and the Y direction. The metal layer 211 is a metal layer in which the bit line BL is formed by post-processes. Next, an insulating film 212 is formed on the metal layer 211. The insulating film 212 is parallel to the X direction and the Y direction. The insulating film 212 is an insulating film in which the plurality of the first layer parts 81 are formed by post-processes. Next, a material, for example, amorphous silicon is formed on the insulating film 212. Therefore, a functional layer 213 is formed. The functional layer 213 is a base of a hard mask.

Next, as shown in part (b) of FIG. 9, the functional layer 213 is subjected to predetermined processings. Therefore, a hard mask M having a pattern corresponding to an arrangement of the bit lines BL is formed from the functional layer 213.

Next, as shown in part (c) of FIG. 9, reactive ion etching is carried out using the hard mask M. Therefore, an unwanted part of the metal layer 211 and an unwanted part of the insulating film 212 are removed. That is, the metal layer 211 is separated into a plurality of metal portions by reactive ion etching such that the separated metal portions are arranged in the X direction. The separated metal portions are the plurality of the bit lines BL. Therefore, the plurality of the bit lines BL are formed from the metal layer 211. Moreover, the metal layer 211 and the insulating film 212 are separated into a plurality of separated portions by reactive ion etching such that the separated portions are arranged in the X direction. Accordingly, the plurality of the first layer parts 81 are formed from the insulating film 212. The first layer part 81 stacked on the first bit line BL-1 is an example of a "first insulating film". The first layer part 81 stacked on the second bit line BL-2 is an example of a "second insulating film".

Next, as shown in part (d) of FIG. 9, an insulator 220 is provided such that the plurality of the bit lines BL and the plurality of the first layer parts 81 are implanted into the insulator 220. The insulator 220 is formed by use of, for example, TEOS (tetraethyl orthosilicate (Si(OC₂H₅)₄).

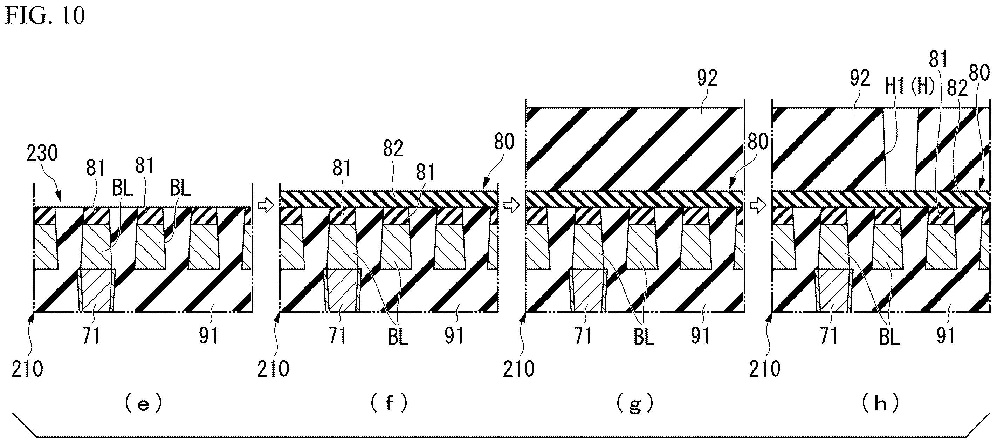

Next, as shown in part (e) of FIG. 10, an upper end portion of the insulator 220 is removed by a planarization process (CMP: Chemical Mechanical Polishing). Therefore, the first insulator 91 is formed from the insulator 220. Consequently, the upper surface of the first insulator 91 is located on the same plane as the upper surfaces of the plurality of the first layer parts 81. Because of this, a structure 230 including the plurality of the bit lines BL, the plurality of the first layer parts 81, and the first insulator 91 is formed.

Next, as shown in part (f) of FIG. 10, the second layer part 82 is formed so as to coat the upper surfaces of the plurality of the first layer parts 81 and the upper surface of the first insulator 91. Accordingly, the insulating layer 80 is formed by the plurality of the first layer parts 81 and the second layer part 82. The second layer part 82 is an example of a "third insulating film".

Next, as shown in part (g) of FIG. 10, the second insulator 92 is formed above the insulating layer 80. The second insulator 92 is formed by use of, for example, TEOS.

Next, as shown in part (h) of FIG. 10, a mask not shown in the drawings is provided on the second insulator 92. A hole H for providing the via 73 is formed on the second insulator 92. The hole H is formed by, for example, reactive ion etching. Firstly, the etching for forming the hole H is carried out under a first condition. The first condition is an etching condition by which the second insulator 92 is etched but the insulating layer 80 is less likely to be etched as compared to the second insulator 92. Consequently, firstly, the hole H1 is formed so as to penetrate through the second insulator 92 in the Z direction and thereby reach the second surface S2 of the insulating layer 80.

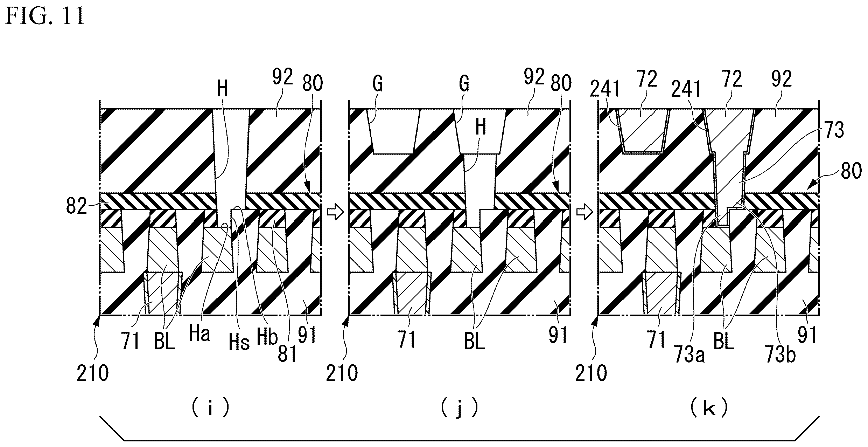

Next, as shown in part (i) of FIG. 11, the etching condition for the hole H is switched to from the first condition to a second condition, and the etching for forming the hole H is carried out. The second condition is an etching condition by which the insulating layer 80 is etched but the first insulator 91 is less likely to be etched as compared to the insulating layer 80.

Consequently, the hole H including a first portion Ha and a second portion Hb is formed. When viewed from the Z direction, the first portion Ha is a portion of the hole H overlapping the bit line BL. The first portion Ha penetrates through the second layer part 82 and the first layer part 81 of the insulating layer 80 in the Z direction. The first portion Ha reaches the surface of the bit line BL (for example, the first bit line BL-1). When viewed from the Z direction, the second portion Hb is a portion of the hole H which is disposed at a position out of the bit line BL. The second portion Hb penetrates through the second layer part 82 of the insulating layer 80 in the Z direction. The second portion Hb is stopped at the upper surface of the first insulator 91. A level difference portion Hs in the Z direction is present between the first portion Ha and the second portion Hb.

Next, as shown in FIG. 11 part (j), a mask not shown in the drawings is provided on the second insulator 92. A groove G for providing the wiring 72 is formed on the upper surface of the second insulator 92. The groove G is formed by, for example, reactive ion etching.

Next, as shown in FIG. 11 part (k), a barrier metal layer 241 is formed on the inner surfaces of the groove G and the hole H. The barrier metal layer 241 becomes the surface layer 72m of the wiring 72 and the surface layer 72m of the via 73. Next, an electroconductive material is provided inside the groove G and the hole H. Therefore, the main part 72n of the wiring 72 and the main part 73n of the via 73 are formed. Consequently, the wiring 72 is formed inside the groove G. The via 73 is formed inside the hole H. At this time, the first conductive portion 73a of the via 73 is formed in the first portion Ha of the hole H. The second conductive portion 73b of the via 73 is formed in the second portion Hb of the hole H.

### <7. Advantage>

As an example, a case is considered in which the bit line BL and the first layer part 81 are not formed by reactive ion etching, but a groove is formed on an upper surface of an insulator and a bit line and an insulator are formed inside the groove. Hereinbelow, the example is referred to as Comparative Example 1. In the Comparative Example 1, it is conceivable that, for example, a groove is formed on an upper surface of an insulator formed of silicon oxide (SiO₂), a bit line is formed at the lower portion inside the groove, and an insulating layer containing silicon nitride (SiN) is an upper portion inside the groove and an upper surface of the above-described insulator. With this configuration, similar to the above-mentioned embodiment, a level difference portion can be provided at a bottom portion of a via.

However, there are a production difficulty and a difficulty to improve electrical characteristics in the configuration of the Comparative Example 1. Specifically, it is necessary to provide a thick insulating layer inside the groove in order to ensure voltage resistance. In other words, in a case in which the via is connected to the first bit line, it is necessary to provide a thick insulating layer inside the groove in order to ensure voltage resistance in order to ensure the distance between the via and a second bit line (non-connection object). In this case, it is necessary to fill a large amount of silicon nitride into a space inside the groove. However, generally, the embedability of silicon nitride is lower than the embedability of silicon oxide. In other words, silicon nitride is less likely to fill the space inside the groove. Therefore, when filling silicon nitride inside of the groove, a void is likely to occur inside silicon oxide. Furthermore, when filling silicon nitride inside of the groove, a large recess (for example, a recess having a depth greater than 10 nm) is likely to occur at an upper surface of a region of an insulating layer corresponding to the upper side of the groove. Such a large recess is depressed toward the inside of the groove from the upper surface of the region of the insulating layer. For this reason, in the configuration of the Comparative Example 1, it may be difficult to increase the voltage resistance or other electrical characteristics.

Next, as an example, a case of a configuration using a thick silicon nitride layer is considered. Hereinbelow, the example is referred to as Comparative Example 2. In the Comparative Example 2, firstly, a metal layer serving as a base of a bit line is formed, a thick silicon nitride layer is formed on the metal layer, and the metal layer and the thick silicon nitride layer are separated into a plurality of separated portions by reactive ion etching such that the separated portions are arranged in a specific direction. Therefore, a plurality of bit lines and a plurality of first insulators provided on the plurality of the bit lines are formed. The plurality of the first insulators correspond one-to-one to the plurality of the bit lines. The plurality of the first insulators are formed of a thick silicon nitride layer described above. The plurality of the first insulators have a large thickness. Next, a second insulator is formed such that the plurality of the bit lines and the plurality of first insulators are implanted into the second insulator. The second insulator includes silicon oxide. Next, of the plurality of the first insulators, a portion corresponding to a position at which a via is formed is removed by reactive ion etching. By this removal, the via is formed in a space portion formed in the second insulator. A wiring (hereinbelow, referred to as a "specific wiring") connected to the via is formed on the remaining first insulators and on the second insulator. With this configuration, the occurrence of displacement of the via with respect to the bit line is suppressed.

However, in the configuration of the Comparative Example 2, a distance between the bit line and the specific wiring in the Z direction is defined by the thickness of the first insulator formed of silicon nitride. Consequently, a thick first insulator is necessary in order to ensure the distance between the bit line and the specific wiring. Here, in a case in which the thickness of the first insulator increases, when separating the above-described metal layer and the thick silicon nitride layer into a plurality of portions by reactive ion etching, a process with a high aspect ratio is required, and in this case, there is a possibility that the thick first insulator collapses. Accordingly, it is difficult to increase the thickness of the first insulator. Therefore, in the configuration of the Comparative Example 2, it is difficult to improve the voltage resistance.

Additionally, in the configuration of the Comparative Example 2, since each of the plurality of the first insulators is separated by reactive ion etching, each of the plurality of the first insulators is separated in a trapezoid shape such that a width of the first insulator becomes wider it approaches the bit line. Hereinbelow, the trapezoid shape is referred to as a "forward tapered trapezoid shape". **In** this case, the first insulator located at a via-hole formation position is removed by reactive ion etching, and therefore a space portion for forming the via is formed inside the second insulator. As a result, the space portion is formed in the forward tapered trapezoid shape along the outer shape of the first insulator. An inlet portion into which an electroconductive material is supplied becomes narrow, and the inside of the space portion becomes wide. Consequently, there is a possibility that embedding failures occur inside the via.

Furthermore, in the configuration of the Comparative Example 2, the region between the bit line and the specific wiring is filled with silicon nitride. Therefore, there is a possibility that the electrical characteristics are degraded such that an interlayer capacitance increases or RC delay may occur.

In contrast, in the embodiment, the insulating layer 80 includes: the first layer part 81 (first portion) stacked on the first bit line BL-1 in the Z direction; the first layer part 81 (second portion) stacked on the second bit line BL-2 in the Z direction; and the second layer part 82 (third portion). The second layer part 82 is located on the opposite side of the bit line BL with respect to the plurality of the first layer parts 81. The second layer part 82 extends at least in the X direction. The first insulator 91 has the portion 91b located between the plurality of the first layer parts 81 of the insulating layer 80. The via 73 has the first conductive portion 73a and the second conductive portion 73b. The first conductive portion 73a penetrates the second layer part 82 and the first layer part 81 of the insulating layer 80 through in the Z direction. The first conductive portion 73a is in contact with the first bit line BL-1. The second conductive portion 73b penetrates through the second layer part 82 of the insulating layer 80 in the Z direction. The second conductive portion 73b is in contact with the first insulator 91. The second conductive portion 73b has the level difference portion 73s between the first conductive portion 73a and the second conductive portion 73b.

With this configuration, since the first layer part 81 and the second layer part 82 are provided, it is possible to form the via 73 having the level difference portion 73s formed on a bottom portion of the via 73. Accordingly, in a case in which the via 73 is connected to the first bit line BL-1, it is possible to ensure the distance between the via 73 and the second bit line BL-2 serving as the non-connection object, and it is possible to increase the voltage resistance. For this reason, it is possible to improve the electrical characteristics of the semiconductor storage device 1.

Moreover, with the above-described configuration of the embodiment, as compared to the configuration of the Comparative Example 2, a process with a high aspect ratio is not required, and it is possible to suppress collapse of the thick first insulator. In other words, with the above-described configuration of the embodiment, since the wiring process is carried out with a low level of difficulty, it is possible to improve the voltage resistance.

Unlike the configuration of the Comparative Example 2, with the above-described configuration of the embodiment, it is not necessary to supply an electroconductive material to the space portion having a forward tapered trapezoid shape. Accordingly, the occurrence of embedding failures inside the via 73 can be suppressed.

Unlike the configuration of the Comparative Example 2, with the above-described configuration of the embodiment, it is possible to adjust the thickness T1 of the first layer part 81 (the thickness of an insulator contributing to voltage resistance) depending on a required voltage resistance. Consequently, the distance between the bottom portion of the via 73 and the second bit line BL-2 can be adjusted by adjusting the thickness T1 of the first layer part 81 depending on a required voltage resistance.

With the above-described configuration of the embodiment, the metal layer 211 and the insulating film 212 are separated into a plurality of separated portions by reactive ion etching such that the separated portions are arranged in the X direction. Therefore, the plurality of the bit lines BL can be formed from the metal layer 211. The plurality of the first layer parts 81 can be formed from the insulating film 212. In this case, a step of filling the inside of the groove with silicon nitride is not necessary. Consequently, as compared to the Comparative Example 1, a void is less likely to occur inside the first layer part 81, and a recess is likely to occur on the second surface S2 of the second layer part 82. For this reason, as compared to the Comparative Example 1, it is easy to increase the thickness T1 of the first layer part 81, and voltage resistance is likely to be ensured. For this reason, it is possible to further improve the electrical characteristics of the semiconductor storage device 1.

In the embodiment, the first insulator 91 includes the insulating material G1 containing oxygen. The first layer part 81 and the second layer part 82 of the insulating layer 80 include the insulating material G2 containing nitrogen. With this configuration, in accordance with the etching selection ratio of the insulating material G2 to the insulating material G1, the hole H having the level difference portion Hs is easily formed between the first portion Ha and the second portion Hb. The hole H is a hole into which the via 73 is to be provided.

In the embodiment, the wiring 72 is disposed on the opposite side of the first bit line BL-1 with respect to the insulating layer 80 in the Z direction. The wiring 72 is connected to the via 73. The second insulator 92 is disposed between the wiring 72 and the insulating layer 80 and at the position out of the via 73. The second insulator 92 includes the insulating material G4 containing oxygen. With this configuration, the second insulator 92 including the insulating material G4 containing oxygen is present between the wiring 72 and the bit line BL. The insulating material G4 containing oxygen (for example, silicon oxide) has a dielectric constant lower than that of silicon nitride. Consequently, for example, as compared to the Comparative Example 2, the interlayer capacitance between the wiring 72 and the bit line BL can be reduced. Accordingly, for example, RC delay can be suppressed, and it is possible to improve the electrical characteristics of the semiconductor storage device 1.

### <8. Modified Examples>

Next, some modified examples will be described. Note that, configurations other than those described in each of the modified examples are the same as the configurations of the aforementioned embodiment.

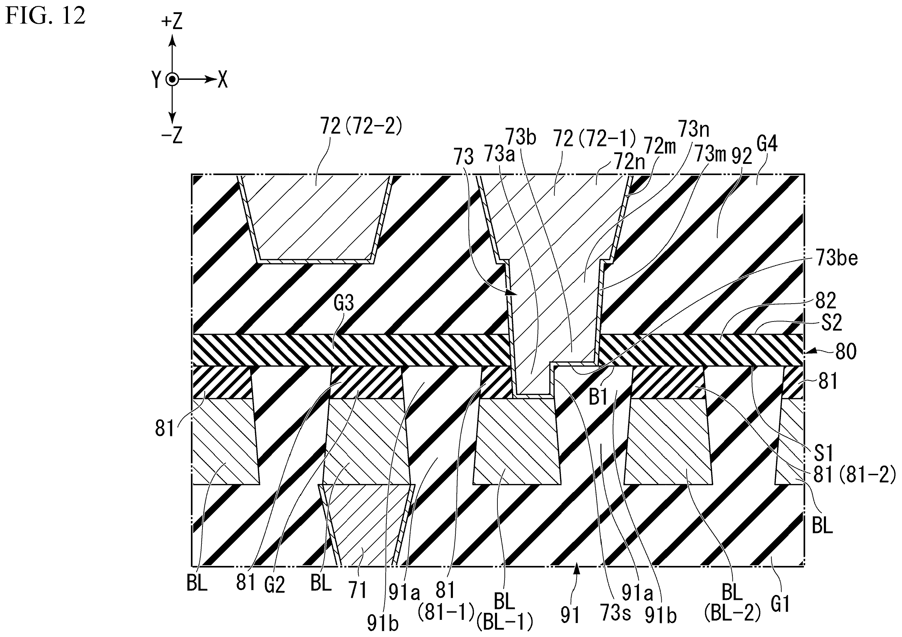

FIG. 12 is a cross-sectional view showing a part of the memory cell array 11 according to the invention.. According to the invention, the first layer part 81 of the insulating layer 80 includes the insulating material G2 containing nitrogen. The insulating material G2 is any one of, for example, silicon nitride (SiN), silicon carbonitride (SiCN), and silicon oxynitride (SiON).

On the other hand, the second layer part 82 of the insulating layer 80 includes an insulating material G3 containing nitrogen. The insulating material G3 is different from the insulating material G2. The insulating material G3 is another of, for example, silicon nitride (SiN), silicon carbonitride (SiCN), and silicon oxynitride (SiON). The insulating material G3 is an example of a "third insulating material".

With this configuration, the insulating layer 80 is formed of a plurality of insulating materials having different characteristics from each other. Therefore, it may be possible to improve the electrical characteristics of the semiconductor storage device 1.

### <8.2 Modified Example>

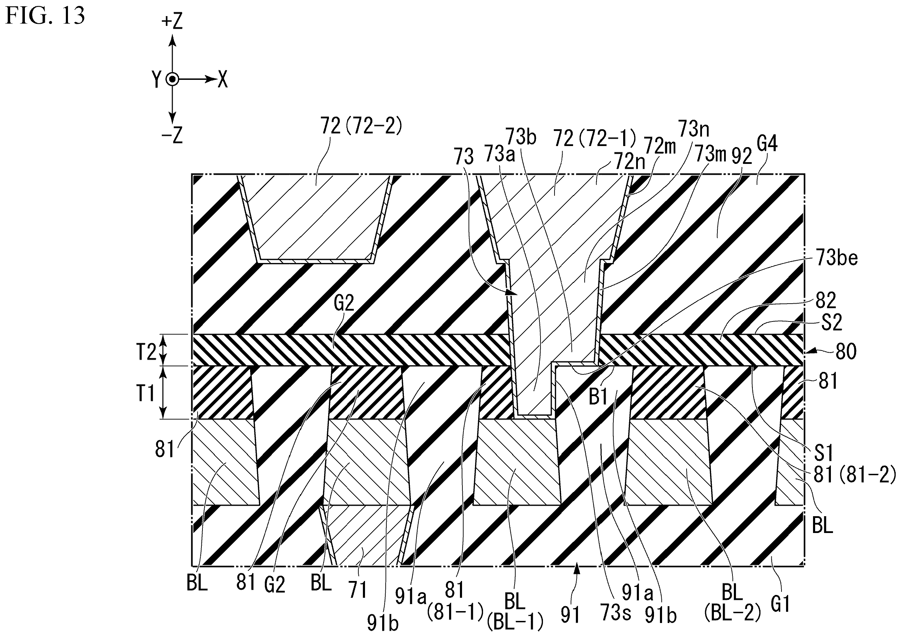

FIG. 13 is a cross-sectional view showing a part of the memory cell array 11 according to a modified example. In the modified example, the
thickness T1 of the first layer part 81 in the Z direction is larger than the thickness T2 of the second layer part 82 in the Z direction. With this configuration, in a case in which a high voltage resistance is required, it is possible to further improve the voltage resistance. According to the modified example, the plurality of the first layer parts 81 are formed by separating the insulating film 212 by reactive ion etching. Therefore, even in a case in which a thick first layer part 81 is provided, a void is less likely to occur inside the first layer part 81, and a recess is likely to occur on the second surface S2 of the second layer part 82.

Although one embodiment and modified examples have been described above, the embodiment and the modified examples are not limited to the above-mentioned examples. For example, the thickness T1 of the first layer part 81 in the Z direction may be smaller than the thickness T2 of the second layer part 82 in the Z direction.

The embodiment and modified example described above are applicable to a semiconductor storage device other than a NAND flash memory. As the semiconductor storage device, for example, a NOR flash memory, a magnetoresistive random access memory (MRAM), a resistive random access memory (ReRAM), or a dynamic random access memory (DRAM) can be adopted. Moreover, the embodiment and modified examples described above are applicable to a semiconductor device other than a semiconductor storage device. As the semiconductor device, for example, a processor such as a CPU (Central Processing Unit) or various IC (Integrated Circuit) components can be adopted. In the present application, ordinal such as "first" and "second" may be rephrased accordingly.

According to at least one embodiment described above, a semiconductor storage device according to an embodiment includes a first wiring, a second wiring, a first insulating layer, a first insulator, and a conductor. The first insulating layer has a first portion, a second portion, and a third portion. The first portion is stacked on the first wiring. The second portion is stacked on the second wiring. The third portion is located on the opposite side of the first wiring and the second wiring with respect to the first portion and the second portion. The conductor has a first conductive portion and a second conductive portion. The first conductive portion penetrates through the third portion and the first portion of the first insulating layer. The first conductive portion is in contact with the first wiring. The second conductive portion penetrates through the third portion of the first insulating layer. The second conductive portion is in contact with the first insulator. The second conductive portion has a level difference portion. The level difference portion is between the first conductive portion and the second conductive portion. With this configuration, it is possible to improve the electrical characteristics.

While certain embodiments have been described, these embodiments have been presented by way of example only, and are not intended to limit the scope of the inventions. The scope of the invention is defined by the accompanying claims.

## Claims

1. A semiconductor storage device comprising:
a first wiring (BL-1) extending in a first direction;
a second wiring (BL-2) apart from the first wiring (BL-1) in a second direction crossing the first direction, the second wiring (BL-2) extending in the first direction;
a first insulating layer (80) having a first portion (81-1), a second portion (81-2), and a third portion (82), the first portion (81-1) being stacked on the first wiring (BL-1) in a third direction crossing the first direction and the second direction, the second portion (81-2) being stacked on the second wiring (BL-2) in the third direction, the third portion (82) being on an opposite side of the first wiring (BL-1) and the second wiring (BL-2) with respect to the first portion (81-1) and the second portion (81-2), the third portion (82) extending in the second direction at least over the first portion (81-1) and the second portion (81-2);
a first insulator (91) having a portion between the first portion (81-1) and the second portion (81-2) of the first insulating layer (80) in the second direction; and
a conductor (73) extending to the first insulating layer (80) from an opposite side of the first wiring (BL-1) with respect to the first insulating layer (80), the conductor (73) having a first conductive portion (73a) a second conductive portion (73b), and a level difference portion (73s), the first conductive portion (73a) penetrating through the third portion (82) and the first portion (81-1) of the first insulating layer (80) in the third direction, the first conductive portion (73a) being in contact with the first wiring (BL-1), the second conductive portion (73b) penetrating through the third portion (82) of the first insulating layer (80) in the third direction, the second conductive portion (73b) being in contact with the first insulator (91), the level difference portion (73s) being between the first conductive portion (73a) and the second conductive portion (73b) in the third direction , wherein
the first insulator (91) includes a first insulating material (G1) containing oxygen,
the first portion (81-1) and the second portion (81-2) of the first insulating layer (80) include a second insulating material (G2) containing nitrogen,
the third portion (82) of the first insulating layer (80) includes a third insulating material (G3),
the third insulating material (G3) contains nitrogen, and
the third insulating material (G3) is different from the second insulating material (G2).

2. The semiconductor storage device according to claim 1, further comprising:
a third wiring (72-1) on an opposite side of the first wiring (BL-1) with respect to the conductor (73), the third wiring (72-1) being connected to the conductor (73), the third wiring (72-1) extending in the first direction or the second direction, and
a second insulator (92) between the third wiring (72-1) and the first insulating layer (80) at a position out of the conductor (73), the second insulator (92) including a fourth insulating material (G4) containing oxygen.

3. The semiconductor storage device according to claim 1, wherein
the first wiring (BL-1) has a first end (101a) and a second end (101b),
the second end (101b) is on an opposite side of the first end (101a) in the third direction,
the first end (101a) is closer to the first insulating layer (80) than the second end (101b), and
a width (W2) of the second end (101b) in the second direction is larger than a width (W1) of the first end (101a) in the second direction.

4. The semiconductor storage device according to claim 3, wherein
the first wiring (BL-1) is formed in a shape on one cross section parallel to the second direction and the third direction, and
a width of the first wiring (BL-1) in the second direction gradually increases in a direction from the first end (101a) to the second end (101b).

5. The semiconductor storage device according to claim 4, wherein
the first wiring (BL-1) is formed in a trapezoid shape.

6. The semiconductor storage device according to any one of claims 1 to 5, further comprising:
a multi-layered body (40) on an opposite side of the first insulating layer (80) with respect to the first wiring (BL-1) and the second wiring (BL-2), the multi-layered body (40) including a plurality of gate electrode layers (41) and a plurality of second insulating layers (42), the plurality of the gate electrode layers (41) and the plurality of the second insulating layers (42) being alternately stacked one by one in the third direction; and
a columnar body (50) extending in the third direction inside the multi-layered body (40), the columnar body (50) including an insulating core (53), a channel layer (52), and a memory film (51), the channel layer (52) being between the plurality of the gate electrode layers (41) and the insulating core (53), the memory film (51) being between the plurality of the gate electrode layers (41) and the channel layer (52).

7. The semiconductor storage device according to claim **6,** wherein
the first wiring (BL-1) is a bit line (BL) electrically connected to the channel layer (52) of the columnar body (50).

8. The semiconductor storage device according to claim **6,** wherein
the first wiring (BL-1) has a first side end (101c) and a second side end (101d) on one cross section parallel to the second direction and the third direction, the first side end (101c) being in contact with the first insulator (91), the second side end (101d) being on an opposite side of the first side end (101c), and
an inside of the first wiring (BL-1) is uniform over a region between the first side end (101c) and the second side end (101d).

9. The semiconductor storage device according to claim **6,** wherein
an inside of the first insulating layer (80) is uniform in a region between a first virtual line (VL1) and the second wiring (BL-2) at least in the third direction, and wherein
the first virtual line (VL1) is a line extending in the second direction along a boundary (B1) between the third portion (82) of the first insulating layer (80) and the first insulator (91) on one cross section parallel to the second direction and the third direction.

10. The semiconductor storage device according to claim **6,** wherein
the third portion (82) of the first insulating layer (80) has a first surface (S1) and a second surface (S2), the first surface (S1) being in contact with the first insulator (91) in the third direction, the second surface (S2) being on an opposite side of the first surface (S1), and
the second surface (S2) does not have a recess having a depth greater than 10 nm in the third direction on a region overlapping the second wiring (BL-2) when viewed from the first direction on one cross section parallel to the second direction and the third direction.

11. A method of manufacturing a semiconductor storage device, comprising:
forming a structure, the structure including a first wiring (BL-1), a second wiring (BL-2), a first insulating film, a second insulating film, and a first insulator (91), the first wiring (BL-1) extending in a first direction, the second wiring (BL-2) being apart from the first wiring (BL-1) in a second direction crossing the first direction, the second wiring (BL-2) extending in the first direction, the first insulating film being stacked on the first wiring (BL-1) in a third direction crossing the first direction and the second direction, the second insulating film being stacked on the second wiring (BL-2) in the third direction, the first insulator (91) having a portion between the first insulating film and the second insulating film in the second direction;
forming a first insulating layer (80) having a first portion (81-1), a second portion (81-2), and a third portion (82) by providing a third insulating film on the first insulating film, on the second insulating film, and on the first insulator (91), the third insulating film extending at least in the second direction, the first portion (81-1) being formed by the first insulating film, the second portion (81-2) being formed by the second insulating film, third portion (82) being formed by the third insulating film;
forming a second insulator (92) on the first insulating layer (80);
forming a hole (H) penetrating through the second insulator (92) and the first insulating layer (80) in the third direction, the hole (H) having a first portion (Ha) and a second portion (Hb) and a level difference portion (Hs), the first portion (Ha) penetrating through the third portion (82) and the first portion (81-1) of the first insulating layer (80) in the third direction, the first portion (Ha) reaching the first wiring (BL-1), the second portion (Hb) penetrating through the third portion (82) of the first insulating layer (80) in the third direction, the second portion (Hb) reaching the first insulator (91), a the level difference portion (Hs) being between the first portion (Ha) and the second portion (Hb); and
forming a conductor (73) inside the hole (H), wherein
the first insulator (91) includes a first insulating material (G1) containing oxygen,
the first portion (81-1) and the second portion (81-2) of the first insulating layer (80) include a second insulating material (G2) containing nitrogen,
the third portion (82) of the first insulating layer (80) includes a third insulating material (G3),
the third insulating material (G3) contains nitrogen, and
the third insulating material (G3) is different from the second insulating material (G2).

12. The method of manufacturing a semiconductor storage device according to claim 11, further comprising:
forming a metal layer (211) parallel to the first direction and the second direction, wherein
the first wiring (BL-1) and the second wiring (BL-2) are formed by separating the metal layer (211) by reactive ion etching such that the separated metal portions are in the second direction.

13. The method of manufacturing a semiconductor storage device according to claim 12, further comprising:
forming an insulating film (212) parallel to the first direction and the second direction on the metal layer (211), wherein
the first insulating film and the second insulating film are formed by separating the metal layer (211) and the insulating film by reactive ion etching such that the separated portions are in the second direction.

## Patentansprüche

1. Eine Halbleiterspeichervorrichtung, umfassend:
eine erste Verdrahtung (BL-1), die sich in einer ersten Richtung erstreckt;
eine zweite Verdrahtung (BL-2), die von der ersten Verdrahtung (Bl-1) in einer zweiten Richtung getrennt ist, die die erste Richtung kreuzt, wobei sich die zweite Verdrahtung (BL-2) in der ersten Richtung erstreckt;
eine erste Isolierschicht (80) mit einem ersten Abschnitt (81-1), einem zweiten Abschnitt (81-2) und einem dritten Abschnitt (82), wobei der erste Abschnitt (81-1) auf der ersten Verdrahtung (BL-1) in einer dritten Richtung gestapelt ist, die die erste Richtung und die zweite Richtung kreuzt, wobei der zweite Abschnitt (81-2) auf der zweiten Verdrahtung (BL-2) in der dritten Richtung gestapelt ist, wobei der dritte Abschnitt (82) auf einer gegenüberliegenden Seite der ersten Verdrahtung (BL-1) und der zweiten Verdrahtung (Bl-2) in Bezug auf den ersten Abschnitt (81-1) und den zweiten Abschnitt (81-2) liegt, wobei sich der dritte Abschnitt (82) in der zweiten Richtung zumindest über den ersten Abschnitt (81-1) und den zweiten Abschnitt (81-2) erstreckt;
einen ersten Isolator (91) mit einem Abschnitt zwischen dem ersten Abschnitt (81-1) und dem zweiten Abschnitt (81-2) der ersten Isolierschicht (80) in der zweiten Richtung; und
einen Leiter (73), der sich von einer gegenüberliegenden Seite der ersten Verdrahtung (BL-1) in Bezug auf die erste Isolierschicht (80) zu der ersten Isolierschicht (80) erstreckt, wobei der Leiter (73) einen ersten leitenden Abschnitt (73a), einen zweiten leitenden Abschnitt (73b) und einen Niveauunterschiedsabschnitt (73s) aufweist, wobei der erste leitende Abschnitt (73a) den dritten Abschnitt (82) und den ersten Abschnitt (81-1) der ersten Isolierschicht (80) in der dritten Richtung durchdringt, wobei der erste leitende Abschnitt (73a) in Kontakt mit der ersten Verdrahtung (BL-1) steht, wobei der erste leitende Abschnitt (73a) in Kontakt mit der ersten Verdrahtung (BL-1) steht, der zweite leitende Abschnitt (73b) den dritten Abschnitt (82) der ersten Isolierschicht (80) in der dritten Richtung durchdringt, der zweite leitende Abschnitt (73b) in Kontakt mit dem ersten Isolator (91) steht, wobei der Niveauunterschiedsabschnitt (73s) zwischen dem ersten leitenden Abschnitt (73a) und dem zweiten leitenden Abschnitt (73b) in der dritte Richtung liegt, wobei
der erste Isolator (91) ein erstes Isoliermaterial (G1) umfasst, das Sauerstoff enthält,
der erste Abschnitt (81-1) und der zweite Abschnitt (81-2) der ersten Isolierschicht (80) ein zweites Isoliermaterial (G2) umfassen, das Stickstoff enthält,
der dritte Abschnitt (82) der ersten Isolierschicht (80) ein drittes Isoliermaterial (G3) umfasst,
das dritte Isoliermaterial (G3) Stickstoff enthält, und
das dritte Isoliermaterial (G3) von dem zweiten Isoliermaterial (G2) verschieden ist.

2. Halbleiterspeichervorrichtung nach Anspruch 1, ferner umfassend:
eine dritte Verdrahtung (72-1) auf einer der ersten Verdrahtung (BL-1) gegenüberliegenden Seite in Bezug auf den Leiter (73), wobei die dritte Verdrahtung (72-1) mit dem Leiter (73) verbunden ist, die dritte Verdrahtung (72-1) sich in der ersten Richtung oder der zweiten Richtung erstreckt, und
einen zweiten Isolator (92) zwischen der dritten Verdrahtung (72-1) und der ersten Isolierschicht (80) an einer Position außerhalb des Leiters (73), wobei der zweite Isolator (92) ein viertes Isoliermaterial (G4) umfasst, das Sauerstoff enthält.

3. Halbleiterspeichervorrichtung nach Anspruch 1, wobei
die erste Verdrahtung (BL-1) ein erstes Ende (101a) und ein zweites Ende (101b) hat,
das zweite Ende (101b) sich auf einer dem ersten Ende (101a) gegenüberliegenden Seite in der dritten Richtung befindet,
das erste Ende (101a) näher an der ersten Isolierschicht (80) liegt als das zweite Ende (101b), und
eine Breite (W2) des zweiten Endes (101b) in der zweiten Richtung größer ist als eine Breite (W1) des ersten Endes (101a) in der zweiten Richtung.

4. Halbleiterspeichervorrichtung nach Anspruch 3, wobei
die erste Verdrahtung (Bl-1) in einer Forma auf einem Querschnitt parallel zu der zweiten Richtung und der dritten Richtung trapezförmig ausgebildet ist, und
eine Breite der ersten Verdrahtung (Bl-1) in der zweiten Richtung graduell in einer Richtung von dem ersten Ende (101a) zu dem zweiten Ende (101b) zunimmt.

5. Halbleiterspeichervorrichtung nach Anspruch 4, wobei
die erste Verdrahtung (BL-1) in einer Trapezform ausgebildet ist.

6. Halbleiterspeichervorrichtung nach einem der Ansprüche 1 bis 5, ferner umfassend:
einen mehrschichtigen Körper (40) auf einer gegenüberliegenden Seite der ersten Isolierschicht (80) in Bezug auf die erste Verdrahtung (BL-1) und die zweite Verdrahtung (BL-2), wobei der mehrschichtige Körper (40) eine Vielzahl von Gateelektrodenschichten (41) und eine Vielzahl von zweiten Isolierschichten (42) umfasst, wobei die Vielzahl der Gateelektrodenschichten (41) und die Vielzahl der zweiten Isolierschichten (42) abwechselnd eine nach der anderen in der dritten Richtung gestapelt sind; und
einen säulenförmigen Körper (50), der sich in der dritten Richtung innerhalb des mehrschichtigen Körpers (40) erstreckt, wobei der säulenförmige Körper (50) einen isolierenden Kern (53), eine Kanalschicht (52) und einen Speicherfilm (51) umfasst, wobei sich die Kanalschicht (52) zwischen der Vielzahl der Gate-Elektrodenschichten (41) und dem isolierenden Kern (53) befindet, und der Speicherfilm (51) zwischen der Vielzahl der Gate-Elektrodenschichten (41) und der Kanalschicht (52) liegt.

7. Halbleiterspeichervorrichtung nach Anspruch 6, wobei
die erste Verdrahtung (BL-1) eine Bitleitung (BL) ist, die elektrisch mit der Kanalschicht (52) des säulenförmigen Körpers (50) verbunden ist.

8. Halbleiterspeichervorrichtung nach Anspruch 6, wobei
die erste Verdrahtung (BL-1) ein erstes Seitenende (101c) und ein zweites Seitenende (101d) auf einem Querschnitt parallel zu der zweiten Richtung und der dritten Richtung hat, wobei das erste Seitenende (101c) in Kontakt mit dem ersten Isolator (91) ist, das zweite Seitenende (101d) auf einer gegenüberliegenden Seite des ersten Seitenendes (101c) ist, und
eine Innenseite der ersten Verdrahtung (BL-1) über einen Bereich zwischen dem ersten Seitenende (101c) und dem zweiten Seitenende (101d) gleichmäßig ist.

9. Halbleiterspeichervorrichtung nach Anspruch 6, wobei
eine Innenseite der ersten Isolierschicht (80) in einem Bereich zwischen einer ersten virtuellen Leitung (VL1) und der zweiten Verdrahtung (BL-2) zumindest in der dritten Richtung gleichmäßig ist, und wobei
die erste virtuelle Leitung (VL1) eine Leitung ist, die sich in der zweiten Richtung entlang einer Grenze (B1) zwischen dem dritten Abschnitt (82) der ersten Isolierschicht (80) und dem ersten Isolator (91) auf einem Querschnitt parallel zu der zweiten Richtung und der dritten Richtung erstreckt.

10. Halbleiterspeichervorrichtung nach Anspruch 6, wobei
der dritte Abschnitt (82) der ersten Isolierschicht (80) eine erste Oberfläche (S1) und eine zweite Oberfläche (S2) aufweist, wobei die erste Oberfläche (S1) mit dem ersten Isolator (91) in der dritten Richtung in Kontakt ist, die zweite Oberfläche (S2) auf einer gegenüberliegenden Seite der ersten Oberfläche (S1) liegt und
die zweite Oberfläche (S2) keine Vertiefung mit einer Tiefe von mehr als 10 nm in der dritten Richtung in einem Bereich aufweist, der die zweite Verdrahtung (Bl-2) überlappt, wenn man sie von der ersten Richtung aus in einem Querschnitt parallel zur zweiten Richtung und zur dritten Richtung betrachtet.

11. Ein Herstellungsverfahren einer Halbleiterspeichervorrichtung, umfassend:
Bilden einer Struktur, wobei die Struktur eine erste Verdrahtung (BL-1), eine zweite Verdrahtung (Bl-2), einen ersten Isolierfilm, einen zweiten Isolierfilm und einen ersten Isolator (91) umfasst, wobei sich die erste Verdrahtung (BL-1) in einer ersten Richtung erstreckt, wobei die zweite Verdrahtung (BL-2) von der ersten Verdrahtung (BL-1) in einer zweiten Richtung, die die erste Richtung kreuzt, entfernt ist, wobei sich die zweite Verdrahtung (BL-2) in der ersten Richtung erstreckt, der erste Isolierfilm auf der ersten Verdrahtung (BL-1) in einer dritten Richtung gestapelt ist, die die erste Richtung und die zweite Richtung kreuzt, der zweite Isolierfilm auf der zweiten Verdrahtung (BL-2) in der dritten Richtung gestapelt ist, der erste Isolator (91) einen Abschnitt zwischen dem ersten Isolierfilm und dem zweiten Isolierfilm in der zweiten Richtung aufweist;
Ausbilden einer ersten Isolierschicht (80) mit einem ersten Abschnitt (81-1), einem zweiten Abschnitt (81-2) und einem dritten Abschnitt (82) durch Vorsehen eines dritten Isolierfilms auf dem ersten Isolierfilm, auf dem zweiten Isolierfilm und auf dem ersten Isolator (91), wobei sich der dritte Isolierfilm zumindest in der zweiten Richtung erstreckt, wobei der erste Abschnitt (81-1) durch den ersten Isolierfilm gebildet wird, der zweite Abschnitt (81-2) durch den zweiten Isolierfilm gebildet wird und der dritte Abschnitt (82) durch den dritten Isolierfilm gebildet wird;
Ausbilden eines zweiten Isolators (92) auf der ersten Isolierschicht (80);
Ausbilden eines Lochs (H), das den zweiten Isolator (92) und die erste Isolierschicht (80) in der dritten Richtung durchdringt, wobei das Loch (H) einen ersten Abschnitt (Ha) und einen zweiten Abschnitt (Hb) aufweist, wobei der erste Abschnitt (Ha) den dritten Abschnitt (82) und den ersten Abschnitt (81-1) der ersten Isolierschicht (80) in der dritten Richtung durchdringt, wobei der erste Abschnitt (Ha)) die erste Verdrahtung (BL-1) erreicht, wobei der zweite Abschnitt (Hb) den dritten Abschnitt (82) der ersten Isolierschicht (80) in der dritten Richtung durchdringt, wobei der zweite Abschnitt (Hb) den ersten Isolator (91) erreicht, wobei der Niveaudifferenzabschnitt (Hs) zwischen dem ersten Abschnitt (Ha) und dem zweiten Abschnitt (Hb) liegt; und
Ausbilden eines Leiters (73) im Inneren des Lochs (H). wobei
der erste Isolator (91) ein erstes Isoliermaterial (G1) umfasst, das Sauerstoff enthält,
der erste Abschnitt (81-1) und der zweite Abschnitt (81-2) der ersten Isolierschicht (80) ein zweites Isoliermaterial (G2) umfassen, das Stickstoff enthält,
der dritte Abschnitt (82) der ersten Isolierschicht (80) ein drittes Isoliermaterial (G3) umfasst,
das dritte Isoliermaterial (G3) Stickstoff enthält, und
das dritte Isoliermaterial (G3) von dem zweiten Isoliermaterial (G2) verschieden ist.

12. Herstellungsverfahren einer Halbleiterspeicherorrichtung nach Anspruch 11, ferner umfassend:
Ausbilden einer Metallschicht (211) parallel zu der ersten Richtung und der zweiten Richtung, wobei
die erste Verdrahtung (BL-1) und die zweite Verdrahtung (BL-2) durch Trennen der Metallschicht (211) durch reaktives Ionenätzen gebildet werden, sodass die getrennten Metallabschnitte in der zweiten Richtung liegen.

13. Herstellungsverfahren einer Halbleiterspeichervorrichtung nach Anspruch 12, ferner umfassend:
Ausbilden eines Isolierfilms (212) parallel zu der ersten Richtung und der zweiten Richtung auf der Metallschicht (211), wobei
der erste Isolierfilm und der zweite Isolierfilm durch Trennen der Metallschicht (211) und des Isolierfilms durch reaktives Ionenätzen gebildet werden, sodass die getrennten Abschnitte in der zweiten Richtung liegen.

## Revendications

1. Dispositif de stockage à semi-conducteur comprenant :
une première ligne conductrice (BL-1), s'étendant dans une première direction ;
une deuxième ligne conductrice (BL-2), séparée de la première ligne conductrice (BL-1) dans une deuxième direction croisant la première direction, la deuxième ligne conductrice (BL-2) s'étendant dans la première direction ;
une première couche isolante (80) présentant une première portion (81-1), une deuxième portion (81-2), et une troisième portion (82), la première portion (81-1) étant empilée sur la première ligne conductrice (BL-1) dans une troisième direction croisant la première direction et la deuxième direction, la deuxième portion (81-2) étant empilée sur la deuxième ligne conductrice (BL-2) dans la troisième direction, la troisième portion (82) étant sur un côté opposé de la première ligne conductrice (BL-1) et de la deuxième ligne conductrice (BL-2) par rapport à la première portion (81-1) et à la deuxième portion (81-2), la troisième portion (82) s'étendant dans la deuxième direction au moins sur la première portion (81-1) et la deuxième portion (81-2) ;
un premier isolant (91) présentant une portion entre la première portion (81-1) et la deuxième portion (81-2) de la première couche isolante (80) dans la deuxième direction ; et
un conducteur (73) s'étendant jusqu'à la première couche isolante (80) depuis un côté opposé de la première ligne conductrice (BL-1) par rapport à la première couche isolante (80), le conducteur (73) présentant une première portion conductrice (73a) et une deuxième portion conductrice (73b), et une portion de différence de niveau (73s), la première portion conductrice (73a) pénétrant à travers la troisième portion (82) et la première portion (81-1) de la première couche isolante (80) dans la troisième direction, la première portion conductrice (73a) étant en contact avec la première ligne conductrice (BL-1), la deuxième portion conductrice (73b) pénétrant à travers la troisième portion (82) de la première couche isolante (80) dans la troisième direction, la deuxième portion conductrice (73b) étant en contact avec le premier isolant (91), la portion de différence de niveau (73s) étant située entre la première portion conductrice (73a) et la deuxième portion conductrice (73b) dans la troisième direction, dans lequel
le premier isolant (91) inclut un premier matériau isolant (G1) contenant de l'oxygène,
la première portion (81-1) et la deuxième portion (81-2) de la première couche isolante (80) incluent un deuxième matériau isolant (G2) contenant de l'azote,
la troisième portion (82) de la première couche isolante (80) inclut un troisième matériau isolant (G3), et
le troisième matériau isolant (G3) contient de l'azote, le troisième matériau isolant (G3) est différent du deuxième matériau isolant (G2).

2. Dispositif de stockage à semi-conducteur selon la revendication 1, comprenant en outre :
une troisième ligne conductrice (72-1) sur un côté opposé de la première ligne conductrice (BL-1) par rapport au conducteur (73), la troisième ligne conductrice (72-1) étant reliée au conducteur (73), la troisième ligne conductrice (72-1) s'étendant dans la première direction ou la deuxième direction, et
un deuxième isolant (92) entre la troisième ligne conductrice (72-1) et la première couche isolante (80) à une position hors du conducteur (73), le deuxième isolant (92) incluant un quatrième matériau isolant (G4) contenant de l'oxygène.

3. Dispositif de stockage à semi-conducteur selon la revendication 1, dans lequel
la première ligne conductrice (BL-1) présente une première extrémité (101a) et une deuxième extrémité (101b),
la deuxième extrémité (101b) est sur un côté opposé de la première extrémité (101a) dans la troisième direction,
la première extrémité (101a) est plus proche de la première couche isolante (80) que la deuxième extrémité (101b), et
une largeur (W2) de la deuxième extrémité (101b) dans la deuxième direction est supérieure à une largeur (W1) de la première extrémité (101a) dans la deuxième direction.

4. Dispositif de stockage à semi-conducteur selon la revendication 3, dans lequel
la première ligne conductrice (BL-1) est formée selon une forme sur une section transversale parallèle à la deuxième direction et à la troisième direction, et
une largeur de la première ligne conductrice (BL-1) dans la deuxième direction augmente graduellement dans une direction allant de la première extrémité (101a) à la deuxième extrémité (101b).

5. Dispositif de stockage à semi-conducteur selon la revendication 4, dans lequel la première ligne conductrice (BL-1) est formée selon une forme trapézoïdale.

6. Dispositif de stockage à semi-conducteur selon l'une quelconque des revendications 1 à 5, comprenant en outre :
un corps multicouche (40) sur un côté opposé de la première couche isolante (80) par rapport à la première ligne conductrice (BL-1) et à la deuxième ligne conductrice (BL-2), le corps multicouche (40) incluant une pluralité de couches d'électrode de grille (41) et une pluralité de deuxièmes couches isolantes (42), la pluralité des couches d'électrode de grille (41) et la pluralité des deuxièmes couches isolantes (42) étant empilées alternativement une par une dans la troisième direction ; et
un corps colonnaire (50) s'étendant dans la troisième direction à l'intérieur du corps multicouche (40), le corps colonnaire (50) incluant un noyau isolant (53), une couche de canal (52), et un film de mémoire (51), la couche de canal (52) étant située entre la pluralité des couches d'électrode de grille (41) et le noyau isolant (53), le film de mémoire (51) étant situé entre la pluralité des couches d'électrode de grille (41) et la couche de canal (52).

7. Dispositif de stockage à semi-conducteur selon la revendication 6, dans lequel
la première ligne conductrice (BL-1) est une ligne de bit (BL) électriquement reliée à la couche de canal (52) du corps colonnaire (50).

8. Dispositif de stockage à semi-conducteur selon la revendication 6, dans lequel
la première ligne conductrice (BL-1) présente une première extrémité latérale (101c) et une deuxième extrémité latérale (101d) sur une section transversale parallèle à la deuxième direction et à la troisième direction, la première extrémité latérale (101c) étant en contact avec le premier isolant (91), la deuxième extrémité latérale (101d) étant sur un côté opposé de la première extrémité latérale (101c), et
un intérieur de la première ligne conductrice (BL-1) est uniforme sur une région située entre la première extrémité latérale (101c) et la deuxième extrémité latérale (101d).

9. Dispositif de stockage à semi-conducteur selon la revendication 6, dans lequel
l'intérieur de la première couche isolante (80) est uniforme dans une région située entre une première ligne virtuelle (VL1) et la deuxième ligne conductrice (BL-2) au moins dans la troisième direction, et dans lequel
la première ligne virtuelle (VL1) est une ligne s'étendant dans la deuxième direction le long d'une limite (B1) entre la troisième portion (82) de la première couche isolante (80) et le premier isolant (91) sur une section transversale parallèle à la deuxième direction et à la troisième direction.

10. Dispositif de stockage à semi-conducteur selon la revendication 6, dans lequel
la troisième portion (82) de la première couche isolante (80) présente une première surface (S1) et une deuxième surface (S2), la première surface (S1) étant en contact avec le premier isolant (91) dans la troisième direction, la deuxième surface (S2) étant située sur un côté opposé de la première surface (S1), et
la deuxième surface (S2) ne présente pas de creux présentant une profondeur supérieure à 10 nm dans la troisième direction sur une région chevauchant la deuxième ligne conductrice (BL-2) lorsqu'elle est vue depuis la première direction sur une section transversale parallèle à la deuxième direction et à la troisième direction.

11. Procédé de fabrication d'un dispositif de stockage à semi-conducteur, comprenant ce qui suit :
le fait de former une structure, la structure incluant une première ligne conductrice (BL-1), une deuxième ligne conductrice (BL-2), un premier film isolant, un deuxième film isolant, et un premier isolant (91), la première ligne conductrice (BL-1) s'étendant dans une première direction, la deuxième ligne conductrice (BL-2) étant séparée de la première ligne conductrice (BL-1) dans une deuxième direction croisant la première direction, la deuxième ligne conductrice (BL-2) s'étendant dans la première direction, le premier film isolant étant empilé sur la première ligne conductrice (BL-1) dans une troisième direction croisant la première direction et la deuxième direction, le deuxième film isolant étant empilé sur la deuxième ligne conductrice (BL-2) dans la troisième direction, le premier isolant (91) présentant une portion située entre le premier film isolant et le deuxième film isolant dans la deuxième direction ;
le fait de former une première couche isolante (80) présentant une première portion (81-1), une deuxième portion (81-2), et une troisième portion (82) en disposant un troisième film isolant sur le premier film isolant, sur le deuxième film isolant, et sur le premier isolant (91), le troisième film isolant s'étendant au moins dans la deuxième direction, la première portion (81-1) étant formée par le premier film isolant, la deuxième portion (81-2) étant formée par le deuxième film isolant, la troisième portion (82) étant formée par le troisième film isolant ;
le fait de former un deuxième isolant (92) sur la première couche isolante (80) ;
le fait de former un trou (H) pénétrant à travers le deuxième isolant (92) et la première couche isolante (80) dans la troisième direction, le trou (H) présentant une première portion (Ha) et une deuxième portion (Hb) et une portion de différence de niveau (Hs), la première portion (Ha) pénétrant à travers la troisième portion (82) et la première portion (81-1) de la première couche isolante (80) dans la troisième direction, la première portion (Ha) atteignant la première ligne conductrice (BL-1), la deuxième portion (Hb) pénétrant à travers la troisième portion (82) de la première couche isolante (80) dans la troisième direction, la deuxième portion (Hb) atteignant le premier isolant (91), la portion de différence de niveau (Hs) étant située entre la première portion (Ha) et la deuxième portion (Hb) ; et
le fait de former un conducteur (73) à l'intérieur du trou (H), dans lequel
le premier isolant (91) inclut un premier matériau isolant (G1) contenant de l'oxygène,
la première portion (81-1) et la deuxième portion (81-2) de la première couche isolante (80) incluent un deuxième matériau isolant (G2) contenant de l'azote,
la troisième portion (82) de la première couche isolante (80) inclut un troisième matériau isolant (G3),
le troisième matériau isolant (G3) contient de l'azote, et
le troisième matériau isolant (G3) est différent du deuxième matériau isolant (G2).

12. Procédé de fabrication de dispositif de stockage à semi-conducteur selon la revendication 11, comprenant en outre ce qui suit :
le fait de former une couche métallique (211) parallèle à la première direction et à la deuxième direction, dans lequel
la première ligne conductrice (BL-1) et la deuxième ligne conductrice (BL-2) sont formées en séparant la couche métallique (211) par gravure ionique réactive de telle sorte que les portions métalliques séparées soient dans la deuxième direction.

13. Procédé de fabrication de dispositif de stockage à semi-conducteur selon la revendication 12, comprenant en outre ce qui suit :
le fait de former un film isolant (212) parallèle à la première direction et à la deuxième direction sur la couche métallique (211), dans lequel
le premier film isolant et le deuxième film isolant sont formés en séparant la couche métallique (211) et le film isolant par gravure ionique réactive de telle sorte que les portions séparées soient dans la deuxième direction.
